# EUROPEAN PATENT APPLICATION

(11) **EP 4 701 376 A2**
(43) Date of publication of application: **25.02.2026**
(21) Application number: 25212807.9
(22) Date of filing: 30.12.2021
(51) Int. Cl.: H10F 77/42

(54) **RECONFIGURABLE INTELLIGENT SURFACE**

(62) Divisional of application: 21847736.2
(71) Applicant: Fraunhofer-Gesellschaft zur Förderung der angewandten Forschung e.V., 80686 München (DE)
(72) Inventor: HAUSTEIN, Thomas, 10587 Berlin (DE); LEATHER, Paul Simon Holt, 14129 Berlin-Schlachtensee (DE); THIELE, Lars, 10587 Berlin (DE); McMENAMY, Jasmina, 10587 Berlin (DE)
(74) Representative: Zimmermann, Tankred Klaus

(57) **Abstract**

A photovoltaic, PV, apparatus for the conversion of light into electrical energy is described. The PV apparatus has a surface to receive incident light, one or more PV elements in or at the surface, the PV element to convert light incident on the surface into electrical energy by the photovoltaic effect, and one or more reconfigurable intelligent surface, RIS, elements in or at the surface, the RIS element operating as reconfigurable intelligent surface, RIS, to direct or reflect one or more incident electromagnetic, EM, waves or one or more incident EM beams incident on the surface from an incident first direction into one or more outgoing EM waves or one or more outgoing EM beams propagating along at least one second direction.

## Description

The present invention relates to the field of propagating one or more electromagnetic, EM, waves or one or more EM beams, more specifically to the field of reconfigurable intelligent surfaces reflecting or redirecting one or more incident EM waves or EM beams. An EM wave or EM beam may be send out by a transmitter and directed towards a receiver, which may be network entities of a wireless communication system or of a sensing system. Embodiments concern a photovoltaic device including RIS functionality, while other embodiments concern a RIS device including an energy harvesting element integrated into its surface.

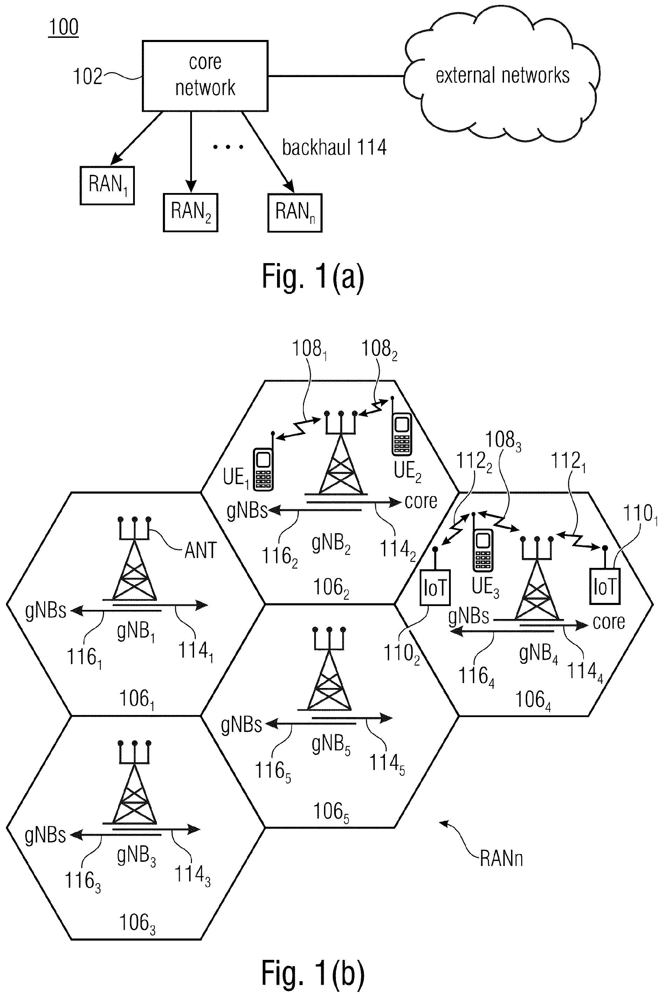

Fig. 1 is a schematic representation of an example of a terrestrial wireless network 100 including, as is shown in Fig. 1(a), the core network 102 and one or more radio access networks RAN₁, RAN₂, ...RAN_{N}. Fig. 1(b) is a schematic representation of an example of a radio access network RANₙ that may include one or more base stations gNB₁ to gNB₅, each serving a specific area surrounding the base station schematically represented by respective cells 106₁ to 106₅. The base stations are provided to serve users within a cell. The one or more base stations may serve users in licensed and/or unlicensed bands. The term base station, BS, refers to a gNB in 5G networks, an eNB in UMTS/LTE/LTE-A/ LTE-A Pro, or just a BS in other mobile communication standards. A user may be a stationary device or a mobile device. The wireless communication system may also be accessed by mobile or stationary IoT devices which connect to a base station or to a user. The mobile or stationary devices may include physical devices, ground based vehicles, such as robots or cars, aerial vehicles, such as manned or unmanned aerial vehicles, UAVs, the latter also referred to as drones, buildings and other items or devices having embedded therein electronics, software, sensors, actuators, or the like as well as network connectivity that enables these devices to collect and exchange data across an existing network infrastructure. Fig. 1(b) shows an exemplary view of five cells, however, the RAN, may include more or less such cells, and RANₙ may also include only one base station. Fig. 1(b) shows two users UE₁ and UE₂, also referred to as user device or user equipment, that are in cell 106₂ and that are served by base station gNB₂. Another user UE₃ is shown in cell 106₄ which is served by base station gNB₄. The arrows 108₁, 108₂ and 108₃ schematically represent uplink/downlink connections for transmitting data from a user UE₁, UE₂ and UE₃ to the base stations gNB₂, gNB₄ or for transmitting data from the base stations gNB₂, gNB₄ to the users UE₁, UE₂, UE₃. This may be realized on licensed bands or on unlicensed bands. Further, Fig. 1(b) shows two further devices 110₁ and 110₂ in cell 106₄, like IoT devices, which may be stationary or mobile devices. The device 110₁ accesses the wireless communication system via the base station gNB₄ to receive and transmit data as schematically represented by arrow 112₁. The device 110₂ accesses the wireless communication system via the user UE₃ as is schematically represented by arrow 112₂. The respective base station gNB₁ to gNB₅ may be connected to the core network 102, e.g., via the S1 interface, via respective backhaul links 114₁ to 114₅, which are schematically represented in Fig. 1(b) by the arrows pointing to "core". The core network 102 may be connected to one or more external networks. The external network may be the Internet, or a private network, such as an Intranet or any other type of campus networks, e.g., a private WiFi communication system or a 4G or 5G mobile communication system. Further, some or all of the respective base station gNB₁ to gNB₅ may be connected, e.g., via the S1 or X2 interface or the XN interface in NR, with each other via respective backhaul links 116₁ to 116₅, which are schematically represented in Fig. 1(b) by the arrows pointing to "gNBs". A sidelink channel allows direct communication between UEs, also referred to as device-to-device, D2D, communication. The sidelink interface in 3GPP is named PC5.

The wireless network or communication system depicted in Fig. 1 may be a heterogeneous network having distinct overlaid networks, e.g., a network of macro cells with each macro cell including a macro base station, like base station gNB₁ to gNB₅, and a network of small cell base stations, not shown in Fig. 1, like femto or pico base stations. In addition to the above-described terrestrial wireless network also non-terrestrial wireless communication networks, NTN, exist including spaceborne transceivers, like satellites, and/or airborne transceivers, like unmanned aircraft systems. The non-terrestrial wireless communication network or system may operate in a similar way as the terrestrial system described above with reference to Fig. 1, for example in accordance with the LTE-Advanced Pro standard or the 5G or NR, new radio, standard.

In mobile communication networks, for example in a network like that described above with reference to Fig. 1, like a LTE or 5G/NR network, there may be UEs that communicate directly with each other over one or more sidelink, SL, channels, e.g., using the PC5/PC3 interface or WiFi direct. UEs that communicate directly with each other over the sidelink may include vehicles communicating directly with other vehicles, V2V communication, vehicles communicating with other entities of the wireless communication network, V2X communication, for example roadside units, RSUs, roadside entities, like traffic lights, traffic signs, or pedestrians. An RSU may have a functionality of a BS or of a UE, depending on the specific network configuration. Other UEs may not be vehicular related UEs and may comprise any of the above-mentioned devices. Such devices may also communicate directly with each other, D2D communication, using the SL channels.

Mobile communication networks, for example in a network like that described above with reference to Fig. 1, like a LTE or 5G/NR network, may make use of a so-called reconfigurable intelligent surface, RIS, as a passive yet configurable network entity. Electrical control of the RIS allows its characteristics to be changed such that the reflection of an electromagnetic, EM, wave incident on the surface may be pointed, focused or dispersed in a certain direction.

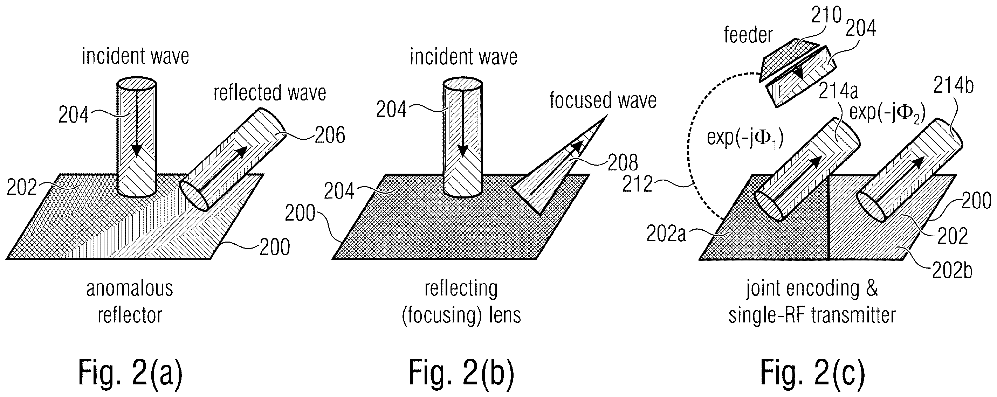

Fig. 2 illustrates examples of how a frequency selective surface may be used to effect a reflection of electromagnetic waves from a medium. In Fig. 2(a) a RIS element 200 is schematically illustrated that is configured to operate as an anomalous reflector receiving on its surface 202 an incident EM wave 204. The incident EM wave 204 is reflected by the surface 202 into a predefined direction, as is illustrated in Fig. 2(a) at 206 denoting the reflected EM wave. Fig. 2(b) illustrates an example of the RIS element 200 being configured as reflecting and focusing lens so that the incident EM wave 204 incident on the surface 202 is reflected as a focused EM wave 208. Fig. 2(c) illustrates a RIS element used for joint encoding together with a single-RF transmitter. The RIS element 200 cooperates with a feeder or transmitter 210 directing the incident EM wave 204 towards the surface 202 of the RIS device 200. As is schematically illustrated at 212, the RIS element 200 is linked to the field 210 so as to allow configuring the field 210 in accordance with predefined configuration information, thereby defining first and second surface areas 202a, 202b causing the incident EM wave 204 to be reflected such that reflected waves 214a and 214b are generated which are directed in the same direction by the RIS element 200 but with the first reflected wave 214a having a phase shift Φ₁ and the second reflected wave 214b having a phase shift Φ₂.

Fig. 2 illustrates the reflection of an incident EM wave 204 from an incident or first direction to a reflected or second direction, however, other examples of RIS elements or devices also allow for a transmission of the incident EM wave, i.e., a RIS may also effect the transfer of an EM wave through its surface rather than being reflected from the surface.

A RIS or RIS device is comprised of a number of elements that may be controlled or configured by electrical means either directly or through the use of additional devices such as electronic components.

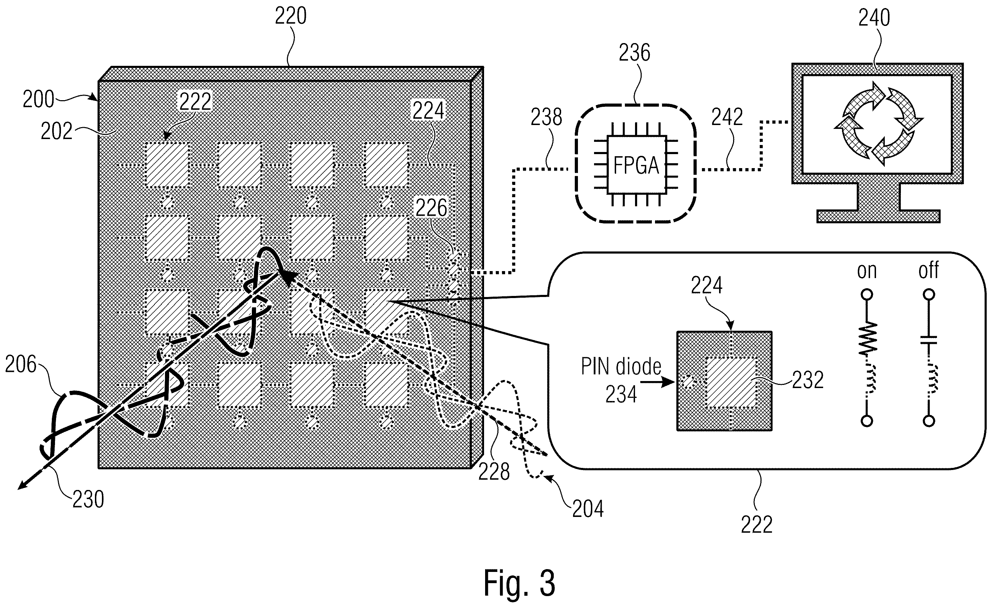

Fig. 3 illustrates an example of a RIS device and shows a simplified arrangement of the components forming a reconfigurable intelligent surface in which the state of a positive-intrinsic-negative, PIN, diode connected to a surface element may be controlled such that electromagnetic waves reflected from the surface may be directed in different directions. Fig. 3 illustrates, schematically, the architecture of a RIS, as described by Cunhua Pan, et al., "Reconfigurable Intelligent Surfaces for 6G Systems: Principles, Applications, and Research Directions", April 20, 2021. The RIS device 200 includes a body 220, which may be formed of a semiconductor material and a surface of which includes a plurality of RIS elements 222. Four rows of four serially connected RIS elements 220 are provided at the surface 202 of the semiconductor body 220. In each row the RIS elements 222 are connected by a bias line 224 leading to a terminal 228 at which respective bias signals may be applied by an external source. The array of RIS elements 222 allows reflecting an incoming EM wave 204 being incident on the surface 202 from a first direction 228, also referred to as the incident direction, into a second or reflected direction 230 along which the reflected EM wave 206 propagates.

Fig. 3 illustrates in the lower right-hand part an enlarged view of a RIS element 222, which includes a reflecting element 232 and a PIN diode 234 that, by controlling the voltage through the biasing line 224, may be switched between on and off modes, as shown in the equivalent circuit at the right-hand part of the enlarged view. To achieve a certain number of phase shift levels, more than one PIN may be integrated in each RIS element 222. The PIN diode 234 of each RIS element 222 is controlled so that the incident EM wave 204 is reflected with the reflected EM wave 206 being shifted in phase by a desired phase shift. The RIS elements 222 may be operated by a controller 236 that may be implemented as a field-programmable gate array, FPGA. The controller 236 is connected to the RIS device 200, as is schematically illustrated by the line 238 connecting the controller 236 to the respective terminals 226 at which the respective bias lines 224 terminate. The controller 236 may be configured by an external device 240, to which the controller 236 is connectable, as is schematically illustrated by the line 242. The RIS device 200, as is illustrated in Fig. 3 has the body 220 including the planar surface 202 and the controller 236. The body 220 may be formed of a single layer or multiple layers, for example, the body 220may be a three-layered structure. The three-layered structure may include an outer layer 202 including the plurality of RIS elements 222 that may be printed on a dielectric substrate to directly act on the incident EM wave 204. A middle layer may be a copper layer to avoid signal or energy leakage, and an inner layer may be a circuit board used for tuning the reflection coefficients of the RIS elements 222. The circuit board may be operated by the controller 236.

Fig. 3 illustrates an example of a RIS device and shows a simplified arrangement of the components forming a reconfigurable intelligent surface in which the state of a positive-intrinsic-negative, PIN, diode connected to a surface element may be controlled such that electromagnetic waves reflected from the surface may be directed in different directions. Fig. 3 illustrates, schematically, the architecture of a RIS, as described by Cunhua Pan, et al., "Reconfigurable Intelligent Surfaces for 6G Systems: Principles, Applications, and Research Directions", April 20, 2021. The RIS device 200 includes a body 220, which may be formed of a semiconductor material and a surface of which includes a plurality of RIS elements 222. Four rows of four serially connected RIS elements 220 are provided at the surface 202 of the semiconductor body 220. In each row the RIS elements 222 are connected by a bias line 224 leading to a terminal 228 at which respective bias signals may be applied by an external source. The array of RIS elements 222 allows reflecting an incoming EM wave 204 being incident on the surface 202 from a first direction 228, also referred to as the incident direction, into a second or reflected direction 230 along which the reflected EM wave 206 propagates.

Fig. 3 illustrates in the lower right-hand part an enlarged view of a RIS element 222, which includes a reflecting element 232 and a PIN diode 234 that, by controlling the voltage through the biasing line 224, may be switched between on and off modes, as shown in the equivalent circuit at the right-hand part of the enlarged view. To achieve a certain number of phase shift levels, more than one PIN may be integrated in each RIS element 222. The PIN diode 234 of each RIS element 222 is controlled so that the incident EM wave 204 is reflected with the reflected EM wave 206 being shifted in phase by a desired phase shift. The RIS elements 222 may be operated by a controller 236 that may be implemented as a field-programmable gate array, FPGA. The controller 236 is connected to the RIS device 200, as is schematically illustrated by the line 238 connecting the controller 236 to the respective terminals 226 at which the respective bias lines 224 terminate. The controller 236 may be configured by an external device 240, to which the controller 236 is connectable, as is schematically illustrated by the line 242. The RIS device 200, as is illustrated in Fig. 3 has the body 220 including the planar surface 202 and the controller 236. The body 220 may be formed of a single layer or multiple layers, for example, the body 220may be a three-layered structure. The three-layered structure may include an outer layer 202 including the plurality of RIS elements 222 that may be printed on a dielectric substrate to directly act on the incident EM wave 204. A middle layer may be a copper layer to avoid signal or energy leakage, and an inner layer may be a circuit board used for tuning the reflection coefficients of the RIS elements 222. The circuit board may be operated by the controller 236.

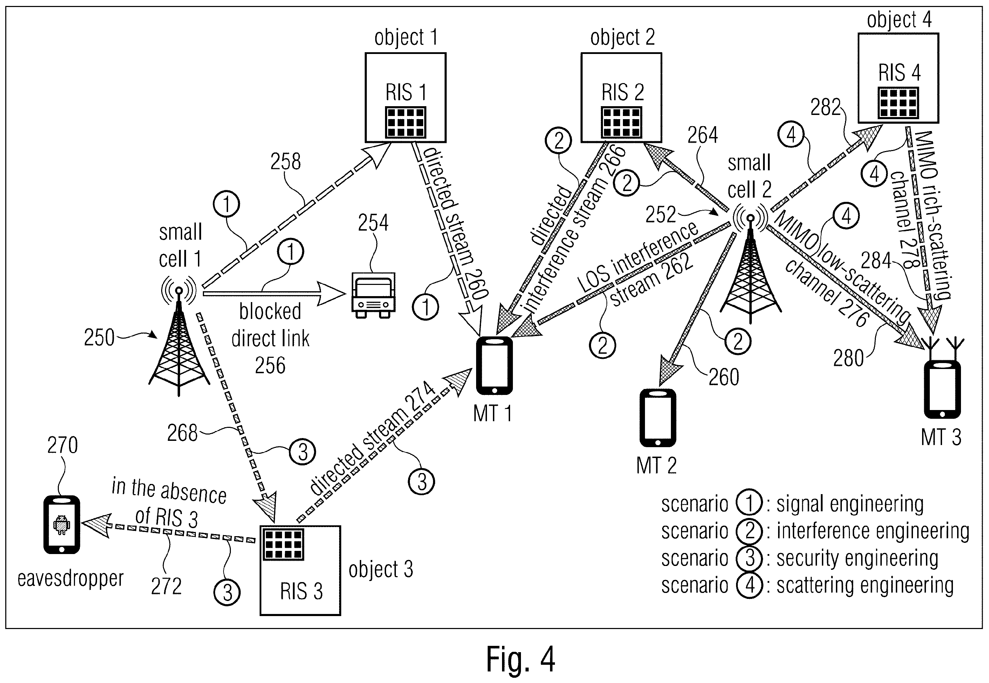

RIS devices, like the one illustrated in Fig. 3, may be employed in different scenarios, for example in a scenario as described in more detail by Di Renzo et al, "Reconfigurable Intelligent Surfaces vs. Relaying: Differences, Similarities, and Performance Comparison", IEEE Open Journal of ComSoc Magazine, June 2020. Fig. 4 illustrates an exemplary smart radio environment as described in the just mentioned publication of Di Renzo. Four scenarios are illustrated, each of which provides a specific example of how a RIS may be used in a wireless communication system, WCS, with a RIS being mounted or fixed to an object, for example an object that is immovable like a building or another fixed structure. The WCS may be a system like the one described above with reference to Fig. 1, and includes two small cells represented by the small cell base stations 250 and 252 serving the user devices or mobile terminals MT1 to MT3. Moreover, within the coverage area of the WCS several objects, namely object 1 to object 4, are present on which respective RIS devices RIS1 to RIS 4 are mounted. Different engineering possibilities are illustrated that may be implemented using the various RIS devices deployed in the WCS.

A signal engineering scenario ① may be implemented for allowing a communication between the small cell base station 250 and the user device MT1 also in situations in which a direct link is blocked. In the signal engineering scenario ① it is assumed that a direct path between the base station 250 and the user device MT1 is at least temporarily blocked, for example by a vehicle 254 passing by and blocking the direct link 256 between the small cell 250 and the user device MT1. In accordance with the signal engineering scenario ①, small cell base station 250 has knowledge about the position of the user device MT1 and about the positons of the respective RIS elements in the system and it may direct a radio beam 258 towards object 1, more specifically towards the RIS device RIS1 which is configured, for example, by the base station 250 via a communication link not illustrated in Fig. 4, to direct the incident radio beam 258 towards the user device MT1 as is illustrated by the directed stream or reflected beam 260.

An interference engineering scenario ② may provide a direct link 262 between the small cell base station 252 and the user device MT2, and for interference engineering a line-of-sight, LoS, interference stream or beam 262 may be directed to the user device MT1 and a non-line-of-sight, NLoS, interference stream may be generated by directing a radio beam 264 from the small cell base station 252 to the RIS device RIS2 mounted on object 2 that is configured to reflect the incident beam 264 as the directed interference beam 266 directed from the RIS device RIS2 towards the user device MT1.

A security engineering scenario ③ may make use of a RIS device to avoid eavesdropping of a communication link. For example, a NLoS communication between the small cell base station 250 and the user device MT1 may cause a radio beam 268 to be directed towards object 3 and reflected by object 3 so that the scattered or reflected beam 272 propagates, in the absence of RIS device RIS3, towards an eavesdropper 270. Providing the RIS device RIS3 at object 3 and controlling it to direct the beam 268 into a desired direction so as to achieve a desired directed beam 274 avoids security issues, like eavesdropping as described above, because beam 268 is directed, by means of the RIS device RIS3, into a desired direction towards user device MT1.

A scattering engineering scenario ④ may employ RIS devices. For example, small cell base station 252 may provide for a communication with the user device MT3 over a MIMO low-scattering channel 276 and over a MIMO rich-scattering channel 278. The low-scattering channel 276 is achieved directing a beam 280 directly from the base station 252 to the user device MT3, while the rich-scattering channel 278 is achieved by directing a beam 282 towards the RIS device RIS4 mounted on object 4 which causes redirecting the incident beam 282 into a reflected beam 284 directed to the user device MT3, thereby providing the rich-scattering channel 280.

It is noted that Fig. 4 does not illustrate how the respective RIS devices RIS1 to RIS4 are controlled so as to provide the respective functionality for implementing the above described scenarios, like coverage improvement (scenario ①), interference management (scenario ②), security strengthening (scenario ③) or an increase of the channel rank (scenario ④). For controlling the respective RIS devices RIS1 to RIS 4 of Fig. 4, one or more controllers may be provided that may be part of the WCS. For example, the respective RIS deices may include controllers that receive information from the network entities of the WCS causing the RIS devices to be configured so as to achieve the desired reflection of incident EM waves into outgoing waves.

Thus, an appropriate deployment of a number of RIS devices may improve the performance of a wireless communication network according to various criteria, like coverage, energy efficiency, reliability, latency, capacity, density and the like.

It is noted that RIS devices may be also employed in other systems or networks than a wireless communication network. For example, a sensing system or network may also make use of RIS devices for directing a measurement beam or a reflected beam into a desired direction. For example, a RIS device may be employed in a radar system or in a radio astronomy system for directing a source wave into a desired direction and/or to direct a reflected wave, for example a wave reflected from an object of interest or under test, onto a receiver of the system.

It is noted that the information in the above section is only for enhancing the understanding of the background of the invention and, therefore, it may contain information that does not form prior art that is already known to a person of ordinary skill in the art.

Starting from the above, there may be a need for improvements or enhancements in the implementation of a reconfigurable intelligent surface, RIS, employed in a system or network for directing or reflecting an incident EM wave towards a desired direction.

Embodiments of the present invention are now described in further detail with reference to the accompanying drawings:
- Fig. 1: is a schematic representation of an example of a terrestrial wireless network;
- Fig. 2: illustrates examples of frequency selective surfaces effecting a reflection of electromagnetic waves from;
- Fig. 3: illustrates an example of a RIS device and shows a simplified arrangement of the components forming a reconfigurable intelligent surface;
- Fig. 4: illustrates an exemplary smart radio environment using RISs mounted or fixed to respective objects;
- Fig. 5: illustrates a photovoltaic, PV, apparatus in accordance with a first embodiment of the first aspect of the present invention;
- Fig. 6: illustrates a photovoltaic, PV, apparatus in accordance with a second embodiment of the first aspect of the present invention;
- Fig. 7: illustrates a photovoltaic, PV, apparatus in accordance with a third embodiment of the first aspect of the present invention;
- Fig. 8: illustrates examples for PV panels including multiple PV apparatuses of Fig. 6 (Fig. 8(a)) or multiple PV apparatuses of Fig. 7 (Fig. 8(b);
- Fig. 9: illustrates a flexible photovoltaic, PV, apparatus in accordance with an embodiment of the first aspect of the present invention and its mounting to a surface;
- Fig. 10: illustrates a further embodiment of a PV apparatus in accordance with the first aspect of the present invention;
- Fig. 11: illustrates a RIS apparatus in accordance with an embodiment of the second aspect of the present invention;
- Fig. 12: illustrates a radio communication system in accordance with an embodiment of the third aspect of the present invention that includes RIS devices implemented by PV panel including integrated RIS functionality in accordance with the first aspect of the present invention, and/or implemented by a RIS device including energy harvesting elements in accordance with the second aspect of the present invention; and
- Fig. 13: illustrates an example of a computer system on which units or modules as well as the steps of the methods described in accordance with the inventive approach may execute.

Embodiments of the present invention are now described in more detail with reference to the accompanying drawings, in which the same or similar elements have the same reference signs assigned.

As described above, for example mobile communication networks, like a network described above with reference to Fig. 1 and Fig. 4, like a LTE or 5G/NR network, may make use of a reconfigurable intelligent surface, RIS. While being a passive network entity the RIS is still a configurable network entity and the configuration requires electrical control of the RIS to allow its characteristics to be changed such that a desired redirection or reflection of an incident electromagnetic, EM, wave is achieved.

However, the energy consumption of information and communication technologies is becoming an increasingly important issue. The information, communication technology, ICT, sector is estimated to currently account for between 5 and 9% of global electricity consumption and more than 2% of global greenhouse gas emissions, and, historically, the roll-out of telecom networks has always come with a growing energy consumption and every time a new standard has been launched - such as 2G, 3G and 4G - the energy consumption has increased significantly.

This is to be avoided with 5G and systems beyond 5G, and it is the responsibility of the industry, the commerce and the government to roll-out fifth generation, 5G, and beyond 5G wireless communication networks while avoiding an increasing energy consumption as much as possible. For example, if 5G were to be deployed in the same way as 3G and 4G, then the energy consumption increases dramatically, with some communications service providers even estimating a doubling of the energy consumption to meet increasing traffic demands. Clearly, this is not sustainable from a cost or environmental perspective. At the same time however, 5G is said to be the most energy-aware standard, due to certain technological improvements such as smarter sleep modes and more efficient data transmission, and it is estimated that such features, combined with a new approach to network roll-out, make it possible to quadruple data traffic without increasing energy consumption.

The above mentioned issues regarding power consumption and the like not only apply for wireless communication networks but also for other networks, like the above mentioned sensing systems for which a reduction in energy usage may be desired.

The present invention addresses the above issues regarding the power consumption in certain systems making use of RIS devices and suggests different aspects for implementing the RIS devices in a way that provides for substantial improvements in the power consumption and also in the operational performance of the devices.

### First Aspect - PV device with integrated RIS device

In accordance with a first aspect of the present invention, a modified photovoltaic, PV, device is provided, like a PV cell, a PV module or a PV panel, that, as usual, receives light on a surface and converts the incident light into electrical energy. The surface of the PV device further includes, in addition to respective PV sections or elements, also RIS sections or elements. In other words, a conventional PV device is modified in accordance with embodiments of the first aspect of the present invention so as to integrate RIS functionality into the PV device, e.g., by forming in addition to the PV elements in or at the surface also RIS elements in or at the surface. In other words, the surface receiving the light to converted into electrical energy includes one or more sections or areas acting as a RIS for redirecting/reflecting one or more incident EM waves or incident EM beams.

Photovoltaic, PV, devices, like solar electricity panels, capture the sun's energy and convert it into electricity. A solar PV panel includes of many cells made from layers of semiconducting material, most commonly silicon. When light shines on this material, a flow of electricity is created. The cells do not need direct sunlight to work and may even work on cloudy days. However, the stronger the sunshine, the more electricity generated. Solar PV systems are made up of several panels, each panel typically generating around 200 - 350 W of energy in strong sunlight. Typical domestic installations comprise 10 to 15 panels and generate direct current, DC, electricity. Because the electricity used for household appliances is alternating current, AC, an inverter is installed along with the system to convert DC electricity to AC electricity. This electricity may either be used throughout a home or may be exported to the electricity grid. Solar PV systems are the leading source of renewable energy for homes and businesses, with more and more buildings opting to have them installed. Alongside this, an increasing number of solar farms is constructed. Solar panels are good for the environment and offer the following benefits:
- reducing the energy production by other sources during the hours of daylight,
- no emissions, thus reducing the carbon footprint of the consumer,
- solar energy is a form of renewable energy unlike fossil fuels which are a finite source of energy,
- long lifetime and low maintenance, e.g., solar panels are expected to last about 50 years.

The number of solar PV installations on existing infrastructure is expected to further increase - not only roof tops but also on building facades and other vertical structures.

By integrating, in accordance with embodiments for the first aspect of the present invention, into PV devices RIS functionality a solution of several problems is provided. Firstly, the need to improve the energy efficiency, reliability, capacity and availability of radio systems, like a wireless communication system or a sensing system, both those that are deployed today and those that may be deployed in the future, and, secondly, the need to provide carbon neutral sources of sustainable electrical power that do not affect green resources, are low in maintenance and are carbon neutral. Although solutions exist in full or part for both of these problems in isolation - for example in the form of intelligent wireless communication systems on the one hand and photovoltaic power systems on the other - the inventors found a common or single solution to both problems.

In line with the trend or need for sustainable energy supplies and the reuse of existing resources, is the use of existing infrastructure or infrastructure that is planned to be deployed. For example, it is expected that in the years to come, a large number of solar panels will need to be deployed in both dense urban environments, like city centers, and urban environments, like suburbs, in order to generate and harvest energy where the operation of fossil-fueled power plants may not be permitted due to air pollution regulations.

At the same time, another trend comes with the availability of new frequency bands for a mobile communication or for sensing purposes - for example the C-band (3.4GHz - 3.8GHz) and larger bandwidths (>100MHz). Such spectrum may be used for 5G-NR deployments which require a densified network deployment to achieve a similar spatial receive signal provisioning in the same coverage area supported by existing 4G-LTE which operate in lower frequency bands - for example, 2.6 GHz, 1.8 GHz, 700 MHz and 800 MHz. The deployment of additional base stations and cell sites requires substantial financial investment and consumes significant amounts of energy during their lifetime of operation. Sustainable deployment methods that require both affordable levels of investment and operational costs are required. Here, the inventors of the present invention have identified a dual use option of the soon-to-be deployed solar panels that will be installed on building roofs and facades, street furniture and other structures. Large areas of solar panels are expected to be deployed on and at the buildings owned by individuals, corporations, public institutions and municipalities. These solar panels are mounted at locations exposed to a reasonable amount of solar incidence over the year. Such locations include building facades and rooftops which are located or positioned in a natural way in between radio infrastructure equipment of a radio communication system, such as base stations, like gNBs, and user equipment devices, UEs, or customer premises equipment, CPEs, and, therefore, are located within a relevant multipath radio propagation environment. Integrating reconfigurable intelligent surfaces, RISs, into solar panels due to their favorable positions and/or locations and the ability of a RIS to actively shape the properties of the radio channel, offers the means to adapt or reconfigure the propagation environment. This offers an improvement of coverage or capacity when compared to the less favorable service parameters experienced when RIS structures are not combined with the deployment of solar panels. Since RIS structures may be designed to be transparent to sunlight, they may be implemented on or integrated into the surface of the solar panels directly without significantly reducing the power conversion efficiency or effectiveness of the solar panel itself.

In accordance with embodiments of the first aspect of the present invention, solar panels and RIS structures are combined into one integrated and/or non-separable entity. This offers both an efficient implementation and dual usage of the same and combined object or apparatus especially when compared to a co-deployment of separate RISs and solar panels.

Furthermore, other systemically required features - for example power supply, a unique device ID, monitoring and/or operations control via communication links - may be shared or used, when at least one of the two functional entities, PV panel and/or RIS, is equipped with such features or means. Furthermore, the redundancy of such connectivity for operational monitoring and control may become a differentiating product feature, a standardized technical requirement, or an operational regulation.

Therefore, embodiments of the first aspect of the present invention provide one or more of the following advantages, without being limited thereto:
- less required space for installation and deployment,
- improved and reduced space consumption of the integrated device,
- advantages in energy and other resource, e.g. communication, consumption compared to a separate deployment and/or use,
- better acceptance by the public due to integrating radio communication/sensing technology into an existing and well accepted device,
- more efficient control through better communication links.

The present invention provides a photovoltaic, PV, apparatus for the conversion of light into electrical energy, the PV apparatus comprising:
a surface to receive incident light,
one or more PV elements in or at the surface, the PV element to convert light incident on the surface into electrical energy by the photovoltaic effect, and
one or more reconfigurable intelligent surface, RIS, elements in or at the surface, the RIS element operating as reconfigurable intelligent surface, RIS, to direct or reflect one or more incident electromagnetic, EM, waves or one or more incident EM beams incident on the surface from an incident first direction into one or more outgoing EM waves or one or more outgoing EM beams propagating along at least one second direction.

In accordance with embodiments, the RIS acts on the incident EM wave or EM beam so as to create a deflected or reflected or diffused or transmitted or focused or diverged or collimated EM wave or EM beam propagating along the second direction.

In accordance with embodiments, the RIS acts on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

In accordance with embodiments, the RIS element comprises one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

In accordance with embodiments,
the apparatus comprises one or more solar panels, and
each of the solar panels comprises an array of PV elements, like solar cells or solar modules, and one or more RIS elements located in a space between the PV elements.

In accordance with embodiments,
the apparatus comprises one or more solar panels, and
each of the solar panels comprises an array of elements, the elements comprising one or more PV elements, like a solar cell or a solar module, and one or more RIS elements.

In accordance with embodiments,
the apparatus comprises one or more solar panels, and
each of the solar panels comprises a plurality of PV elements, like solar cells or solar modules, arranged in a first layer of a body of the PV apparatus, and a plurality of RIS elements arranged in a second layer of the body, and
the first layer is closer to the surface receiving the incident light than the second layer, and is transparent to the EM wave or EM beam, or
the second layer is closer to the surface receiving the incident light than the first layer, and is transparent to light.

In accordance with embodiments,
the apparatus is a solar cell, and
the apparatus comprises a semiconductor substrate,
wherein a PV element, like a photodiode, is formed in a first area of the semiconductor substrate, and a RIS element is formed in a second area of the semiconductor substrate.

In accordance with embodiments,
the apparatus comprises a plurality of semiconductor elements,
the semiconductor elements are selectively configurable to operate as
- a PV element, or
- a RIS element, or
- a first element neither converting any incident light into electrical energy by the photovoltaic effect nor redirecting or reflecting the incident EM wave or EM beam, e.g., as an element that reflects, like a mirror, or passes, like a window pane, the light and the EM wave or EM beam, or
- a second element converting any incident light into electrical energy by the photovoltaic effect and redirecting or reflecting the incident EM wave or EM beam.

In accordance with embodiments,
- N semiconductor elements, N being a positive integer greater than 1,
- n1 semiconductor elements configured as PV element,
- n2 semiconductor elements configured as a RIS element,
- n3 semiconductor elements configured as a first element, and
- n4 semiconductor elements configured as a second element,
with each of n1, n2, n3, n4 ≥ 0, and each of n1, n2, n3, n4 ≤ N.

In accordance with embodiments, each of n1, n2, n3, n4 and/or a pattern of respective PV elements, RIS elements, first elements and second elements is determined responsive to an input from one or more of the following:
- a radio communication system or a sensing system using the EM wave or EM beam,
- a radio communication system or a sensing system different from the one using the EM wave or EM beam, e.g., a system experiencing interferences in view of the EM wave or EM beam,
- an operator of the PV apparatus,
- a grid to which the PV apparatus is connected,
- a manufacturer of the PV apparatus.

In accordance with embodiments, a PV element is reconfigured as a RIS element in one or more of the following situations:
- if an amount of light convertible into electrical energy is at or below a predefined threshold, e.g., during night time or in case of a shading of the PV element from the light,
- if an amount of light convertible into electrical energy is at or above a predefined threshold, e.g., during excessively bright periods of time, like an incident solar energy level at or above a threshold, or in case of a saturation of an energy storage device, like a battery, connected to the PV apparatus, or in case a network or grid to which the PV apparatus is connected does not accept any electrical energy,
- if a radio communication system or a sensing system using the EM wave or EM beam requests an increase of an amount of RIS provided for the EM wave or EM beam, e.g., in case a coverage need and/or a capacity need in a radio communication system increases beyond a predefined threshold.

In accordance with embodiments,
the PV element and the RIS element are formed in a common layer of the semiconductor substrate, or
the PV element is formed in a first layer of the semiconductor substrate, and the RIS element is formed in a second layer of the semiconductor substrate, with the first layer being closer to a surface receiving the incident light than the second layer, and transparent to the EM wave or EM beam, or with the second layer being closer to the surface receiving the incident light than the first layer, and transparent to light.

In accordance with embodiments, the PV apparatus comprises a single layer or multilayer rigid structure including the PV elements and the RIS elements, like a semiconductor substrate or a support plate, or a single layer or multilayer flexible structure including the PV elements and the RIS elements, like a foil or a film.

In accordance with embodiments,
the light to be converted into electrical energy by the PV effect comprises light in the visible or invisible part of the electromagnetic spectrum, e.g., visible light in the wavelengths from 380 nm to 700 nm or ultraviolet radiation or infrared radiation, and
the EM wave or EM beam to be directed or reflected from the incident first direction to the second/third direction comprises an EM wave or EM beam in the electromagnetic spectrum used by a radio communication system, like a 3GPP wireless communication network or a WiFi system, or by a sensing system, like radar and or radio astronomy.

In accordance with embodiments, the PV apparatus comprises a RIS controller, the RIS controller to configure the RIS to direct or reflect the incident EM wave or EM beam in the second/third direction.

In accordance with embodiments, the RIS controller comprises a processor configured to perform one or more of the following operations:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

In accordance with embodiments,
the RIS controller comprises a memory holding the control parameter and/or the control instruction, the RIS controller being preconfigured with the control parameter and/or the control instruction or receiving the control parameter and/or the control instruction from a remote unit, e.g., via a radio link from a network entity of a radio communication system or from a sensing system, and
the control parameter and/or the control instruction defines one or more of the following properties of the EM wave or EM beam propagating along the second/third direction:
   - a desired phase shift,
   - a desired signal-to-noise ratio, SNR,
   - a desired signal-to-noise-and-interference ratio, SINR,
   - a desired beamwidth,
   - a desired direction,
   - a desired polarization,
   - a desired cross-polar discrimination, XPD,
   - a desired orbital angular momentum, OAM,
   - a desired amplification or attenuation,
   - a desired channel rank,
   - a desired beam sweep,
   - a desired functionality of the RIS deployment,
   - a desired functionality of the sensing elements,
   - a desired functionality of the transmitting elements,
   - a desired frequency translation ,e.g., mixing products or frequency shifts.

In accordance with embodiments, the RIS controller is to communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

In accordance with embodiments, the PV apparatus comprises a PV controller, like a charge controller, and/or an inverter and/or a grid connection controller, wherein the PV controller or an inverter controller or the grid connection controller further comprises the RIS controller.

In accordance with embodiments, the PV apparatus comprises a RIS communication device for a communication with one or more entities, like a base station or a user device, of a radio communication system or a sensing system using the EM wave or EM beam to operate.

In accordance with embodiments, the RIS communication device further allows for a communication with one or more entities of the PV environment, like an operator of the PV apparatus, the grid to which the PV apparatus is connected or the manufacturer of the PV apparatus, and wherein the PV apparatus may communicate one or more of the following:
- a unique identification of the PV apparatus,
- an activation of the PV apparatus,
- a registration of the PV apparatus,
- a theft or misuse of the PV apparatus,
- a performance report of the PV apparatus,
- a signal for controlling the ganging or interconnecting with one or more further PV apparatus.

In accordance with embodiments, the PV apparatus comprises a Global Navigation Satellite System, GNSS, positioning system, like GPS, BeiDou, or GLONASS.

In accordance with embodiments, the RIS is operated using at least a part of the electrical energy obtained by converting the light incident on the surface.

In accordance with embodiments, the PV apparatus comprises one or more energy harvesting elements in or at the surface, the energy harvesting element to convert a radiation incident on the surface into electrical energy, and to provide the electrical energy to the RIS for operating the RIS, e.g., for operating a RIS controller and/or a RIS communication device.

In accordance with embodiments, the PV apparatus comprises an energy storage for storing electrical energy, e.g., energy obtained by converting the light incident on the surface or energy obtained by the energy harvesting element, the energy storage coupled to the RIS for providing electrical energy for operating the RIS, e.g., for operating a RIS controller and/or a RIS communication device.

In accordance with embodiments, the PV apparatus is connectable to one or more PV panels with integrated RIS functionality and/or one or more further RIS panels, and
wherein the PV apparatus is to provide the electrical energy generated by the PV elements or by the energy harvesting elements for use or storage to the one or more PV panels with integrated RIS functionality and/or to the one or more further RIS panels, and/or
wherein the PV apparatus is to receive additional electrical energy for operating the RIS, e.g., for operating the RIS controller and/or the RIS communication device, from the one or more PV panels with integrated RIS functionality and/or from the one or more further RIS panels, e.g., if an amount of energy generated by the PV apparatus is at or below a predefined threshold.

In accordance with embodiments, the PV apparatus comprises
a radiation absorbing structure for converting an incident radiant energy into thermal energy or into electrical energy,
wherein the RIS acts on the incident EM wave or EM beam so as to cause a part of the incident EM wave or EM beam to be directed to the radiation absorbing structure.

### Second Aspect - RIS device with integrated power supply

In accordance with a second aspect of the present invention, a modified RIS device is provided which includes, in addition to the RIS elements formed in or at a surface thereof, also energy harvesting elements which are also provided in or at the surface of the device, for example PV elements or elements converting an incident electromagnetic radiation into electrical energy by electromagnetic induction. In other words, the RIS, i.e., the surface receiving the EM wave or EM beam includes one or more sections or areas for converting an incident electromagnetic radiation into electrical energy.

By integrating, in accordance with embodiments for the second aspect of the present invention, energy harvesting elements into a surface of an RIS device a solution of several problems is provided. Firstly, the need to improve the energy efficiency, reliability, capacity and availability of radio systems, like a wireless communication system or a sensing system, both those that are deployed today and those that may be deployed in the future, and, secondly, the need to provide carbon neutral sources of sustainable electrical power that do not affect green resources, are low in maintenance and are carbon neutral. Although solutions exist in full or part for both of these problems in isolation - for example in the form of intelligent wireless communication systems on the one hand and photovoltaic power systems on the other - the inventors found a common or single solution to both problems.

As mentioned earlier, new frequency bands for a mobile communication or for sensing purposes become available - for example the C-band (3.4GHz - 3.8GHz) and larger bandwidths (>100MHz). Such spectrum may be used for 5G-NR deployments which require a densified network deployment to achieve a similar spatial receive signal provisioning in the same coverage area supported by existing 4G-LTE which operate in lower frequency bands - for example, 2.6 GHz, 1.8 GHz, 700 MHz and 800 MHz. The deployment of additional base stations and cell sites requires substantial financial investment and consumes significant amounts of energy during their lifetime of operation. Sustainable deployment methods that require both affordable levels of investment and operational costs are required. Here, the inventors of the present invention have identified a dual use option of the RIS to be employed avoiding the need to provide a separate power supply. Integrating into reconfigurable intelligent surfaces, RISs, one or more energy harvesting elements, like PV elements or electromagnetic induction elements, offers a stand-alone or self-contained means to adapt or reconfigure the propagation environment, i.e., without the need to provide a separate power supply.

In accordance with embodiments of the second aspect of the present invention, RIS structures and energy harvesting elements are combined into one integrated and/or non-separable entity. This offers both an efficient implementation and dual usage of the same and combined object or apparatus especially when compared to a co-deployment of separate RISs and power supplies. Embodiments of the second aspect of the present invention provide one or more of the following advantages, without being limited thereto:
- less required space for installation and deployment, as no separate power supply is needed,
- improved and reduced space consumption of the integrated device,
- advantages in energy and other resource, e.g. communication, consumption compared to a separate deployment and/or use,
- more efficient control through better communication links.

The present invention provides an apparatus for the reflection or redirection of one or more incident electromagnetic, EM, waves or one or more incident EM beams used by a radio communication system, like a 3GPP wireless communication network or a WiFi system, or by a sensing system, like radar and or radio astronomy, from an incident first direction into one or more outgoing EM waves or one or more outgoing EM beams propagating along at least one second direction, the apparatus comprising:
a surface to receive the incident EM wave or EM beam,
one or more reconfigurable intelligent surface, RIS, elements in or at the surface, the RIS element operating as reconfigurable intelligent surface, RIS, to reflect or redirect the incident EM wave or EM beam from the incident first direction to the second direction, and
one or more energy harvesting elements in or at the surface, the energy harvesting element to convert a radiation incident on the surface into electrical energy, and to provide the electrical energy to the RIS for operating the RIS, e.g., for operating a RIS controller and/or a RIS communication device.

In accordance with embodiments, the RIS acts on the incident EM wave or EM beam so as to create a deflected or reflected or diffused or transmitted or focused or diverged or collimated EM wave or EM beam propagating in the second direction.

In accordance with embodiments, the RIS acts on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

In accordance with embodiments, the RIS element comprises one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

In accordance with embodiments, the radiation incident on the surface comprises a radiation in the visible or invisible part of the electromagnetic spectrum, e.g., visible light in the wavelengths from 380 nm to 700 nm or ultraviolet radiation or infrared radiation, and the one or more energy harvesting elements are configured to convert the radiation into electrical energy by the photovoltaic effect.

In accordance with embodiments, the radiation incident on the surface comprises the radiation of the EM wave or EM beam to be directed or reflected to the second/third direction, and the one or more energy harvesting elements are configured to convert the radiation into electrical energy by electromagnetic induction.

In accordance with embodiments, the apparatus comprises a single layer or multilayer rigid structure including the RIS elements and the energy harvesting elements, like a semiconductor substrate or a support plate, or a single layer or multilayer flexible structure including the RIS elements and the energy harvesting elements, like a foil or a film.

In accordance with embodiments, the apparatus comprises a RIS controller, the RIS controller to configure the RIS to direct or reflect the incident EM wave or EM beam in the second/third direction.

In accordance with embodiments, the RIS controller comprises a processor configured to perform one or more of the following operations:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

In accordance with embodiments,
the RIS controller comprises a memory holding the control parameter and/or the control instruction, the RIS controller being preconfigured with the control parameter and/or the control instruction or receiving the control parameter and/or the control instruction from a remote unit, e.g., via a radio link from a network entity of a radio communication system or from a sensing system, and
the control parameter and/or the control instruction defines one or more of the following properties of the EM wave or EM beam propagating in the second/third direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation ,e.g., mixing products or frequency shifts.

In accordance with embodiments, the RIS controller is to communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

In accordance with embodiments, the apparatus comprises a RIS communication device for a communication with one or more entities, like a base station or a user equipment device, of a radio communication or of a sensing system using the EM wave or EM beam.

In accordance with embodiments, the apparatus comprises a Global Navigation Satellite System, GNSS, positioning system, like GPS, BeiDou, or GLONASS.

In accordance with embodiments,
the apparatus comprises a plurality of semiconductor elements,
the semiconductor elements are selectively configurable to operate as
- a RIS element, or
- an energy harvesting element, or
- a first element neither converting an incident radiation into electrical energy nor redirecting or reflecting the incident EM wave or EM beam, e.g., as an element that reflects, like a mirror, or passes, like a window pane, the radiation and the EM wave or EM beam, or
- a second element converting an incident radiation into electrical energy and redirecting or reflecting the incident EM wave or EM beam.

In accordance with embodiments, the apparatus comprises
- N semiconductor elements, N being a positive integer greater than 1,
- n1 semiconductor elements configured as RIS element,
- n2 semiconductor elements configured as an energy harvesting element,
- n3 semiconductor elements configured as a first element, and
- n4 semiconductor elements configured as a second element,
with each of n1, n2, n3, n4 ≥ 0, and each of n1, n2, n3, n4 ≤ N.

In accordance with embodiments, each of n1, n2, n3, n4 and/or a pattern of respective RIS elements, energy harvesting elements, first elements and second elements is determined responsive to an input from one or more of:
- a radio communication system or a sensing system using the EM wave or EM beam,
- a radio communication system or a sensing system different from the one using the EM wave or EM beam, e.g., a system experiencing interferences in view of the EM wave or EM beam.

In accordance with embodiments, an energy harvesting element is reconfigured as a RIS element in one or more of the following situations:
- if an amount of radiation convertible into electrical energy is at or below a predefined threshold, e.g., during night time or in case of a shading of the PV element from the light,
- if an amount of radiation convertible into electrical energy is at or above a predefined threshold, e.g., during excessively bright periods of time, like an incident solar energy level at or above a threshold, or in case of a saturation of an energy storage device, like a battery, connected to the PV apparatus, or in case a network or grid to which the PV apparatus is connected does not accept any electrical energy,
- if a radio communication system or a sensing system using the EM wave or EM beam requests an increase of an amount of RIS provided for the EM wave or EM beam, e.g., in case a coverage need and/or a capacity need in a radio communication system increases beyond a predefined threshold.

In accordance with embodiments, the apparatus comprises an energy storage for storing the electrical energy obtained by converting the radiation incident on the surface.

In accordance with embodiments,
the apparatus is connectable to one or more PV panels with integrated RIS functionality and/or one or more further RIS panels, and
wherein the apparatus is to provide the electrical energy generated by the one or more energy harvesting elements for use or storage to the one or more PV panels with integrated RIS functionality and/or to the one or more further RIS panels, and/or
wherein the apparatus is to receive additional electrical energy for operating the RIS, e.g., for operating the RIS controller and/or the RIS communication device, from the one or more PV panels with integrated RIS functionality and/or from the one or more further RIS panels, e.g., if an amount of energy generated by the apparatus is at or below a predefined threshold.

In accordance with embodiments, the apparatus comprises
radiation absorbing structure for converting an incident radiant energy into thermal energy or into electrical energy,
wherein the RIS acts on the incident EM wave or EM beam so as to cause a part of the incident EM wave or EM beam to be directed to the radiation absorbing structure.

### Third Aspect - System

In accordance with a third aspect of the present invention, a system transmitting/receiving EM waves is provided including one or more apparatuses or devices in accordance with the first aspect of the present invention and/or one or more apparatuses and/or devices in accordance with the second aspect of the present invention.

The present invention provides a system for a reflection or redirection of an electromagnetic, EM, wave used by a radio communication system, like a 3GPP wireless communication network or a WiFi system, or by a sensing system, like radar and or radio astronomy, from an incident first direction to a second direction, the system comprising:
a plurality of apparatuses which are communicatively linked,
wherein the plurality of apparatuses comprising one or more of the inventive apparatuses, and
wherein at least one of the apparatuses is to control the RIS functionality provided by the plurality of apparatuses.

Embodiments of the inventive aspects are now described in more detail. In the following description of embodiments of the inventive aspects reference is made to an incident EM wave or EM beam to be directed or reflected by a RIS into an outgoing EM wave or EM beam propagating along at least one certain direction. However, the present invention is not limited to just one incident EM wave or to just one incident EM beam. Rather two or more incident EM waves or incident EM beams may be received on the RIS. Moreover, any incident EM wave or EM beam may be directed or reflected by a RIS into more than one outgoing EM wave or EM beam propagating along the same direction or along different directions. For example, in practice it is expected that there are more than one wave or beam incident on the RIS and that at least some types of RIS have the capability of creating more than one reflected/directed beam.

In the following description of embodiments of the present invention, reference is made to a RIS or RIS elements, which may a known structure, as it is, e.g., described by Cunhua Pan, et al., "Reconfigurable Intelligent Surfaces for 6G Systems: Principles, Applications, and Research Directions", April 20, 2021, or by Sharma, T.; Chehri, A.; Fortier, P. Reconfigurable Intelligent Surfaces for 5G and beyond Wireless Communications: A Comprehensive Survey. Energies 2021, 14, 8219 (https://doi.org/10.3390/en14248219). For example, a RIS element may include one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

### First Aspect - PV device with integrated RIS device

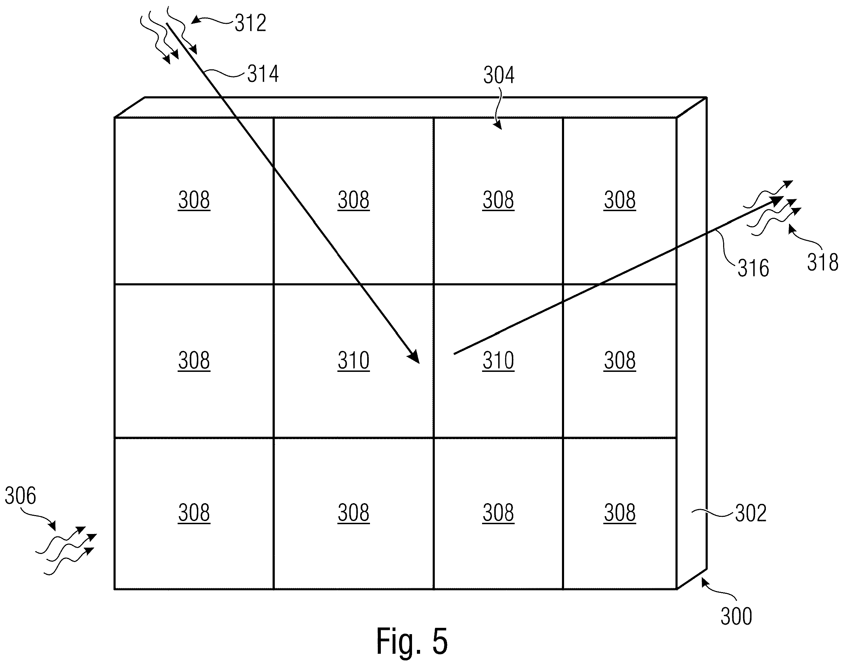

In accordance with embodiments of the first aspect of the present invention, a photovoltaic device is provided that receives light on the surface thereof, and the surface further includes, in addition to sections or elements converting the light into electrical energy, also sections or elements operating as a reconfigurable intelligent surface, RIS. Fig. 5 schematically illustrates a photovoltaic, PV, apparatus 300 in accordance with an embodiment of the first aspect of the present invention. The PV apparatus 300 is provided to convert incident light into electrical energy using the PV effect, and includes a body 302 having a surface 304 to receive incident light 306. The surface 304 includes one or more PV elements 308 for converting the incident light 306 into electrical energy by the photovoltaic effect, as well as one or more RIS elements 310 to direct or reflect an electromagnetic, EM, wave 312 from an incident or first direction 314 to at least one second direction 316 along which the redirected or reflected outgoing EM wave 318 propagates. In other words, the one or more PV elements 308 and the one or more RIS elements 310 are provided in or at the light receiving surface 304 of the PV apparatus 300.

In accordance with embodiments, some or all of the RIS elements 310 provide a RIS for a certain incident EM wave so as to create, e.g., as described above with reference to Fig. 2, a deflected or reflected or diffused or transmitted or focused or diverged or collimated EM wave propagating along the second direction. The second direction may also be a direction extending through the PV apparatus 300 so that in case the PV apparatus 300 or at least the RIS parts thereof is/are formed from materials being transparent for the incident EM wave, the incident EM wave is transmitted, i.e., passes through PV apparatus 300.

In the embodiment of Fig. 5, PV elements 308 for converting the light 306 into electrical energy are provided in the top and bottom rows and at either end of the center row, thereby surrounding the RIS elements 310 in the center row. It is noted that the arrangement of the respective PV elements 308 and RIS elements 310 in Fig. 5 is just one possible implementation. The inventive solution is not limited to the depicted approach, rather, more or less PV/RIS elements may be provided in different patterns, as shall be described in more detail below.

Fig. 5 illustrates an embodiment of a PV apparatus which may be a PV panel comprised of the PV elements 308, and in the very same PV panel also the RIS functionality is integrated by providing in or at the light receiving surface the one or more RIS elements 310, thereby achieving the above described advantages of the first aspect of the present invention and avoiding any drawbacks as they are encountered when implementing the PV panel and the RIS panel as separate elements, for example the need for a side-by-side integration on a mounting surface or mounting structure, like a roof or within a common enclosure or in a common mounting board, thereby reducing the footprint of the overall device. A conventional PV apparatus, which includes a plurality of PV elements integrated into its surface, may be modified in accordance with embodiments of the first aspect of the present invention by integrating the RIS functionality into the surface, for example by interweavingly integrating the PV elements and the RIS elements in or at a surface of a common body of the apparatus.

In accordance with further embodiments, the RIS elements and PV elements may be provided on top of each other, for example by providing the RIS elements on top of the PV elements and using a material for forming the RIS elements that is transparent to the incident light 306. In accordance with other embodiments, the PV elements may be manufactured in a way that they are transparent to the incident/outgoing EM wave 312/318 and are placed above the RIS elements. In either case, a reduced footprint of the overall apparatus is achieved when compared to a separate implementation of the PV and RIS devices. For example, the body 302 of the PV apparatus may include one or more first or PV layers in which the respective PV elements are arranged, and one or more second or RIS layers in which the respective RIS elements are arranged. In case PV layer is closer to the surface 304 receiving the incident light than the RIS layer, the PV layer is transparent to the EM wave. Otherwise, in case the RIS layer is closer to the surface receiving the incident light than the PV layer, the RIS layer is transparent to light.

In accordance with embodiments, the RIS elements may be implemented or integrated within the PV apparatus, like a PV panel, so as to obtain a sparse RIS structure or a sparse array of RIS elements in between the PV elements of a larger PV device, which is sufficient for effectively redirecting or deflecting an incident EM wave.

In accordance with embodiments, the PV structures or layers inside the PV apparatus may be used as a ground plane for the RIS elements.

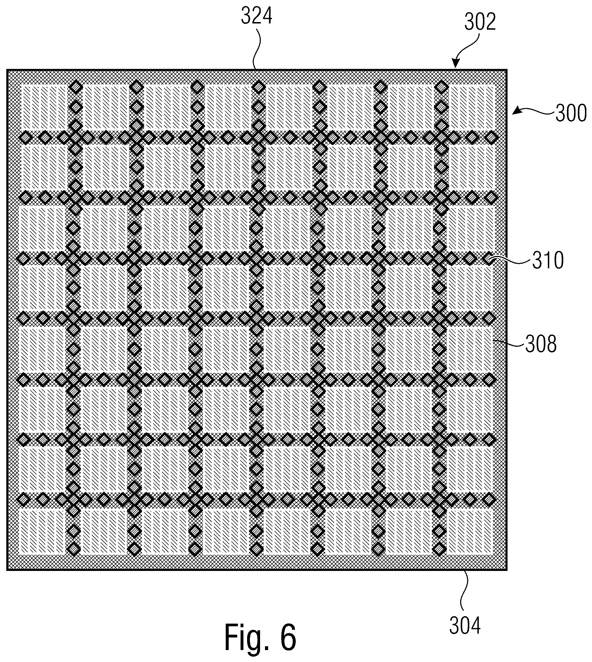

In the embodiment of Fig. 5, reference has been made to a PV apparatus which, as mentioned above, may be a solar panel. In accordance with embodiments, the apparatus includes one or more solar panels each comprising the PV elements, like solar cells or solar modules, and the one or more RIS elements may be located in a space between the PV elements. Fig. 6 illustrates an embodiment of such a PV apparatus 300 which includes the body 302 on the surface 304 of which an array of PV elements 308 and a plurality of RIS elements 310 are formed. The RIS elements 310 are in a space 324 between the PV elements 308. Thus, in accordance with the embodiment of Fig. 6, the space 324 between the PV elements 308 is used for the RIS elements 310. By means of the arrangement of the RIS elements 310 in the depicted form, the above-mentioned sparse array of RIS elements 310 is obtained which is sufficient for effectively redirecting or deflecting an incident EM wave 312.

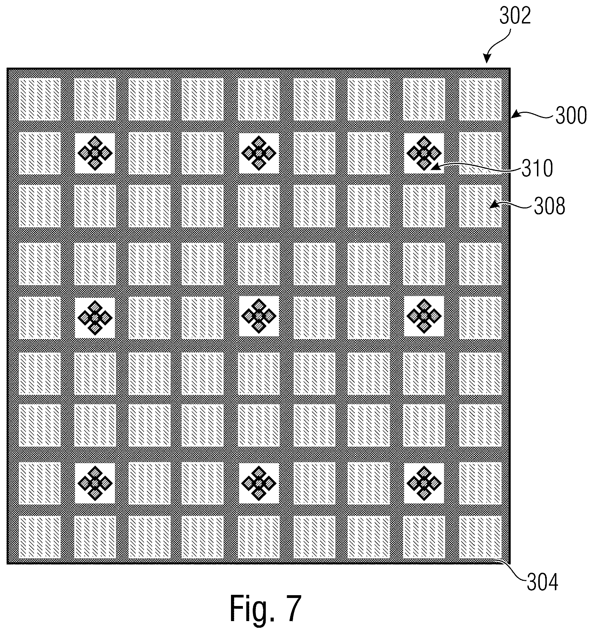

Fig. 7 illustrates another embodiment of the first aspect of the present invention showing the PV apparatus 300 and the body 302 on a surface of which the PV elements 308 and the RIS elements 310 are formed. Other than in the embodiment of Fig. 6, in accordance with the embodiment of Fig. 7, some of the sites or locations in the conventional array of PV elements are configured as RIS elements 310, i.e., some of the space in the array normally occupied by a PV element or a PV cell is used for a RIS element instead.

It is noted that the embodiments described above with reference to Figs. 5 to 7 are of exemplary nature only and, dependent on the circumstances, different patterns of RIS elements among the PV elements may be selected. For example, the proportion of area devoted to PV and devoted to RIS may be varied, for example between 20% RIS and 80% PV, 50% RIS and 50% PV or even 60% RIS and 40% PV.

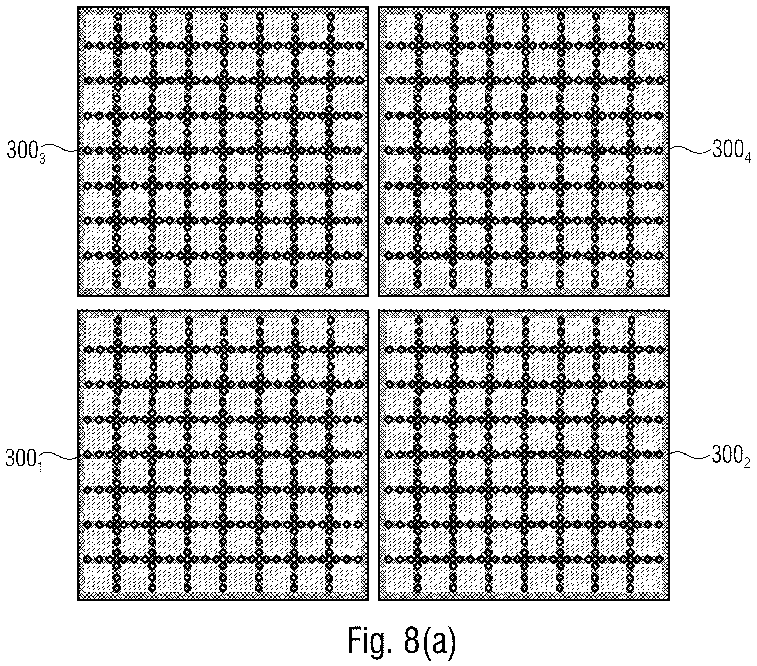

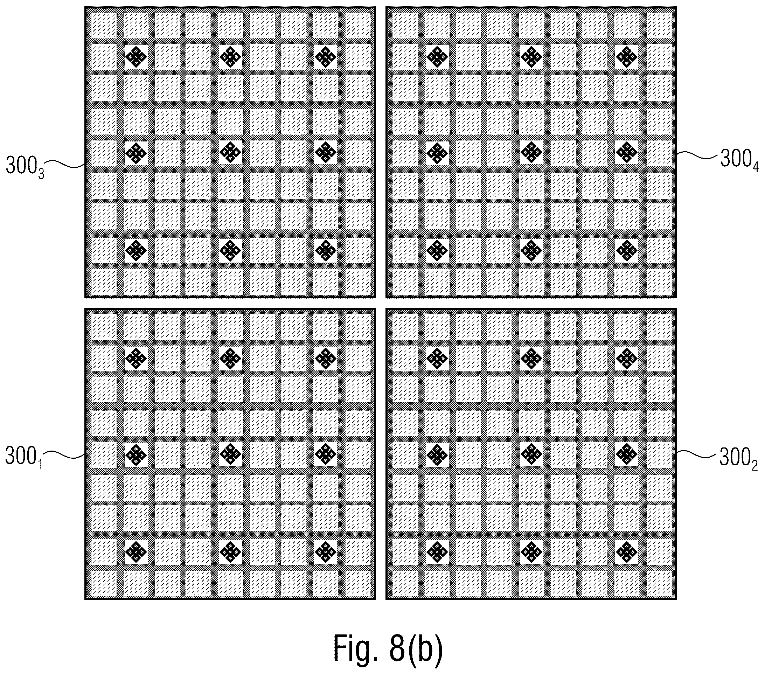

In the embodiments of Figs. 5 to 7 a single PV apparatus is illustrated, which may be a PV panel. However, in accordance with further embodiments, the apparatus may comprise a plurality of PV panels, and Fig. 8 illustrates examples for PV panels including multiple PV apparatuses of Fig. 6 (see Fig. 8(a)) or multiple PV apparatuses of Fig. 7 (see Fig. 8(b)). As is illustrated in Fig. 8, the apparatus includes four panels 300₁ to 300₄ being structured in accordance with the embodiments of Figs. 6 or 7. Naturally, also a mixture of the embodiments from Figs. 6 and 7 may be used and, also, the number of panels may be more or less than the four panels depicted in Fig. 8.

In accordance with the embodiments as described thus far, the body 302 of the PV apparatus 300 was comprised, at least, in part of a rigid semiconductor substrate in which the respective PV elements and RIS elements are formed. In accordance with other embodiments, the body 302 may be a multilayer structure including, for example, a circuit board to which respective PV elements, like PIN photodiodes, as well as the additional RIS elements (see for example Fig. 3) are mounted in a certain pattern.

However, the inventive approach in accordance with the first aspect is not limited to a rigid or non-flexible body 302, rather, in accordance with other embodiments, the body 302 of the PV apparatus may be a flexible body, for example, it may be a film or a foil comprising both the PV elements and the RIS elements in a way as described above with reference to the preceding embodiments. For example, the body, at least in the part where no PV elements and RIS elements, are formed, may be transparent to light so that the flexible structure may be applied to or adhered to elements designed to pass light, such as windows, a building cladding, screens or divisors.

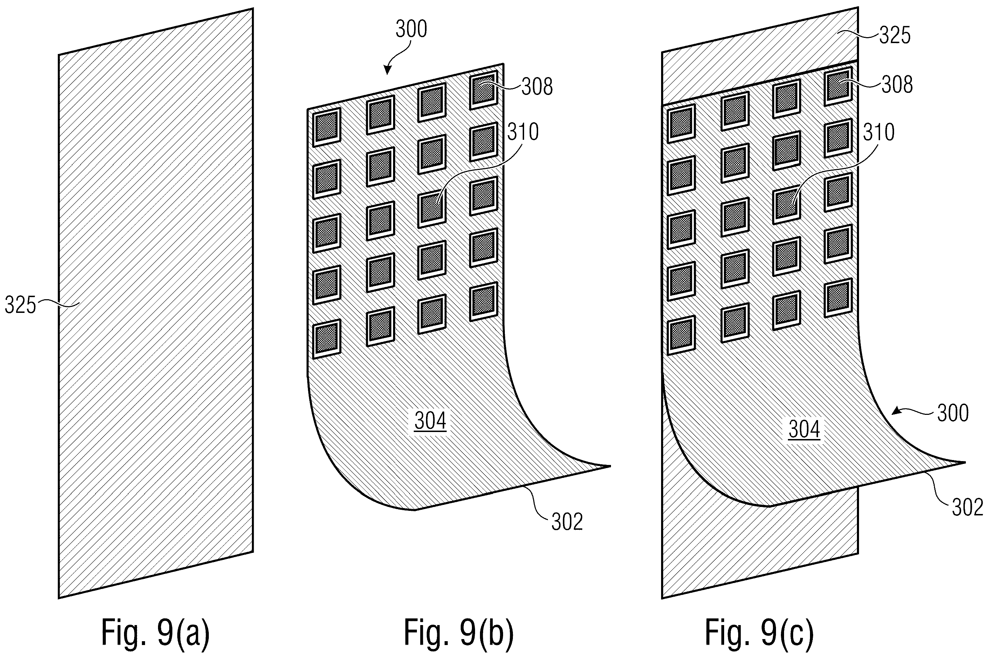

Fig. 9 illustrates an embodiment using a flexible substrate or body 302. Fig. 9(a) shows a structure 325, like a window or a glass wall, to which the inventive PV apparatus 300 having a flexible body 302, as depicted in Fig. 9(b), may be adhered. Fig. 9(c) illustrates mounting or adhering the PV apparatus to the window 325.

In accordance with further embodiments, the PV apparatus may be, as mentioned above, a PV panel or a PV module or even only a PV cell in which part of the PV cell is implemented as the PV element while another part of the PV cell is implemented as the RIS element.

In accordance with embodiments the PV apparatus 300 has a body 302 may including a single or multi-layered substrate, for example, a semiconductor substrate which, in turn, includes a plurality of semiconductor elements. The semiconductor elements include the PV elements 308, like respective photo diodes, e.g., PIN photo diodes, and the RIS elements, like respective PIN diodes for switching on/off a reflecting element (see, e.g., reflecting element 232 in Fig. 3).

In accordance with the embodiments described so far, it is assumed that the PV panel includes the PV elements and the RIS elements distributed on or at the surface 304 of the body 302 of the PV apparatus in a certain pattern of PV elements and RIS elements. In other words, in the embodiments described so far, it was assumed that at or in the respective areas or sections of the surface either a PV element or a RIS element is provided. However, in accordance with other embodiments, the structure of the PV apparatus may be such that it comprises in or at the surface 304 of body 302 respective elements, like semiconductor elements, that are configurable so as to either operate as PV element or as RIS element. For example, the apparatus body 302 may comprise a single or multi-layered substrate including, for example, a semiconductor substrate which includes a plurality of semiconductor elements, for example PIN diodes, that may be selectively configured to operate as a PV element or as a RIS element. For example, when making use of PIN diodes, such diodes may be configurable in such a way that when being turned off they operate as PIN photodiodes so that light incident on the surface 304 is converted into electrical energy in accordance with the photovoltaic effect. When being turned on they may actuate a reflective element allowing reflection of the incident electromagnetic wave.

In accordance with further embodiments, some or all of the plurality of semiconductor elements may be selectively configured to operate as an element that neither converts any incident light into electrical energy by the photovoltaic effect nor redirects or reflects the incident EM wave. Such an element may reflect the light and the EM wave like a mirror, or pass, like a window pane, the light and the EM wave.

In accordance with yet further embodiments, some or all of the plurality of semiconductor elements may be selectively configured to operate as an element that combines PV and RIS functionality, e.g., as an element converting any incident light into electrical energy by the photovoltaic effect and redirecting or reflecting the incident EM wave or EM beam.

In accordance with embodiments using configurable semiconductor elements, one or more of the mentioned semiconductor elements are configured as PV elements, thereby defining the one or more PV elements 308, and one or more of the semiconductor elements may be configured as a RIS element, thereby defining the one or more second RIS elements 310. In accordance with embodiments, a semiconductor element that is used as a PV element at one time may be reconfigured into a RIS element for another time, for example in case an amount of light that may be converted into electrical energy is at or below or certain threshold. For example, during nighttime most or all of the semiconductor elements may be configured as RIS elements. Also during daytime, it may be that some of the PV elements are determined to be sufficiently illuminated by light, for example by direct sunlight, while it is determined that others do not receive direct sunlight and are shaded so that the PV elements receiving sunlight are effective to produce energy while the shaded elements are less effective and, therefore, may be reconfigured to operate as a RIS element, at least for the time during which the incident light is below a threshold, i.e., as long as they are shaded.

In accordance with other embodiments, a semiconductor element that is used as a PV element at one time may be configured into a RIS element also if an amount of light convertible into electrical energy is at or above a predefined threshold. For example, during excessively bright periods of time, an incident solar energy level may be at or above a threshold so that a desired amount of electrical energy to be provided by the PV panel may be obtained by less than the currently used PV elements so that PV elements no longer needed to reach the desired electrical output of the PV panel may be configured into RIS elements, e.g., for further supporting the RIS functionality provided by the PV panel. Also, there may be situations in which an energy storage device, like a battery, connected to the PV apparatus reached or is about to reach its maximum charging level, or in which a network or grid to which the PV apparatus is connected does not accept any electrical energy or only a certain level of electrical energy. Also in such situations, for reducing the energy output of the PV panel, PV elements may be configured into RIS elements, e.g., for further supporting the RIS functionality provided by the PV panel.

In accordance with other embodiments, if a radio communication system or a sensing system using the EM wave requires an increase of an amount of RIS provided for the EM wave, a semiconductor element that is used as a PV element may be configured into a RIS element. For example, in case a coverage need and/or a capacity need in a radio communication system increases beyond a predefined threshold, a respective configuration may be requested by the system.

It is noted that, in accordance with embodiments, configuring the respective elements may also lead to situations in which all elements are PV elements or in which all elements are RIS elements.

In accordance with further embodiments, some or all of the plurality of semiconductor elements may be selectively configured to operate as a first specific element that neither converts any incident light into electrical energy by the photovoltaic effect nor redirects or reflects the incident EM wave. Such an element may reflect the light and the EM wave like a mirror, or pass, like a window pane, the light and the EM wave.

In accordance with yet further embodiments, some or all of the plurality of semiconductor elements may be selectively configured to operate as a second specific element that combines PV and RIS functionality, e.g., as an element converting any incident light into electrical energy by the photovoltaic effect and redirecting or reflecting the incident EM wave or EM beam.

When considering the above embodiments making use of configurable elements or non-configurable elements, for example, the PV apparatus 300 may include in total N semiconductor elements, with N being a positive integer greater than 1. Among these elements, there may be
- n1 semiconductor elements configured as PV element 308,
- n2 semiconductor elements configured as a RIS element 310,
- n3 semiconductor elements configured as a first specific element, and
- n4 semiconductor elements configured as a second specific element.

In accordance with embodiments, each of n1, n2, n3, n4 ≥ 0 and each of n1, n2, n3, n4 ≤ N. In other words, in accordance with embodiments,
- the number of PV elements in the PV apparatus may be from 0 to N,
- the number of RIS elements in the PV apparatus may be from 0 to N,
- the number of first specific elements in the PV apparatus may be from 0 to N,
- the number of second specific elements in the PV apparatus may be from 0 to N.

For example, in case of configurable elements n1, n2, n3, n4 and/or a pattern of respective PV elements, RIS elements, first specific elements and second specific elements may be set or determined responsive to an input from one or more of the following:
- a radio communication system or a sensing system using the EM wave or EM beam,
- a radio communication system or a sensing system different from the one using the EM wave or EM beam, e.g., a system experiencing interferences in view of the EM wave or EM beam,
- an operator of the PV apparatus,
- a grid to which the PV apparatus is connected,
- a manufacturer of the PV apparatus.

In accordance with embodiments, the PV element and the RIS element are formed in a common layer of the semiconductor substrate, or the PV element is formed in a first layer of the semiconductor substrate, and the RIS element is formed in a second layer of the semiconductor substrate, with the first layer being closer to the surface 304 receiving the incident light 306 than the second layer, and transparent to the EM wave 312, or with the second layer being closer to the surface 304 receiving the incident light 306 than the first layer, and transparent to light.

In the embodiments described so far, reference has been made to incident light 306 as being the radiation received by the PV apparatus to be converted into electrical energy. It is noted that the inventive approach is not limited to the visible range of the electromagnetic spectrum, like wavelengths from 380 nm to 700 nm, but also invisible radiation of the electromagnetic spectrum may be transformed or converted into electrical energy by the photovoltaic effect, for example radiation in the ultraviolet spectrum.

With regard to the incident EM radiation or wave 312, reference has been made so far to the electromagnetic spectrum used by a radio communication system, like a 3 GPP wireless communication network or a WiFi system, however, in accordance with other embodiments, the incident electromagnetic wave 312 may also be in the electromagnetic spectrum used by a sensing system for directing sensing energy towards a certain direction or for receiving from a certain direction energy reflected, e.g., by a device under test.

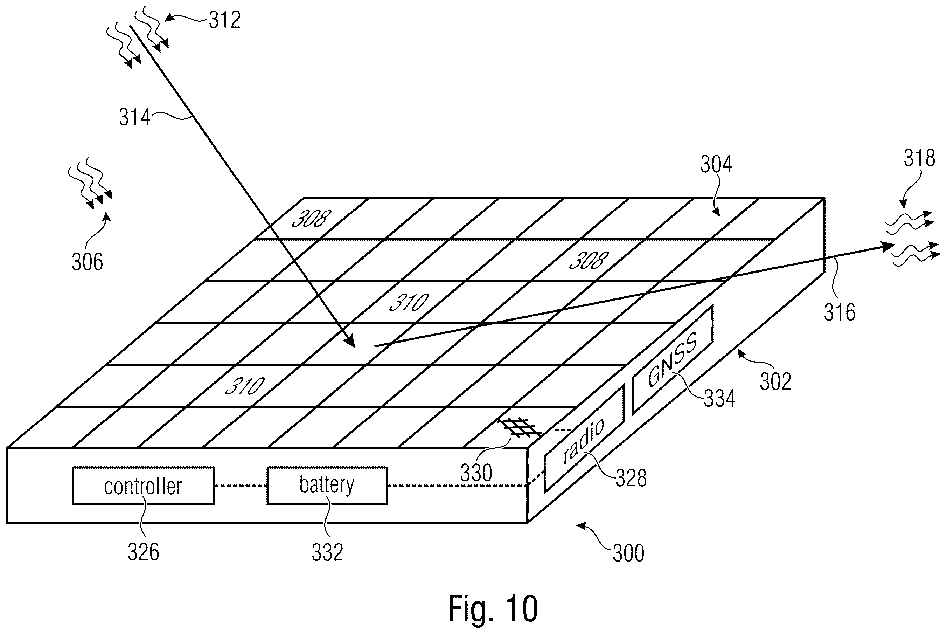

Fig. 10 illustrates a further embodiment of the PV apparatus in accordance with the first aspect of the present invention. The PV apparatus 300 may be implemented as in any of the preceding embodiments described above with reference to Figs. 5 to 9, and further comprises a RIS controller 326 that may be formed inside the body 302. The RIS controller 326 is provided to control the RIS or RIS elements so as to direct or reflect the incident EM wave 312 in the second direction 316. For example, the RIS controller 326, e.g., by means of a processor, may perform one or more of the following:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

The RIS controller 326 may comprises a memory for holding the control parameter and/or the control instruction. In accordance with embodiments, the RIS controller 326 may be preconfigured with the control parameter and/or the control instruction. For example, the RIS controller may be preconfigured with the control parameter and/or the control instruction
- at a time of initial connection of the PV apparatus 300 with a communication or sensing system making use of the RIS,
- at a time of provisioning the PV apparatus 300 for operation with the communication or sensing system, e.g., by inserting a memory device or by activating an embedded memory device, or
- at a time of manufacturing the PV apparatus 300, e.g., by storing the control parameter and/or the control instruction in the memory of the RIS controller 326.

In accordance with other embodiments, the RIS controller 326 may receive the control parameter and/or the control instruction from a remote unit, e.g., via a radio link from a network entity of a radio communication system or from a sensing system. Moreover, the RIS controller 326 may select e.g., responsive to a certain signaling from the network side, a certain set of control parameters for achieving a desired deflection or reflection of the incident EM wave 312.

The RIS controller 326 may configure the RIS 310 according to the one or more control parameters and/or the control instruction, so as to define one or more of the following properties of the EM wave or EM beam propagating along the second direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation, e.g., mixing products or frequency shifts.

The processor may communicate with one or more network entities of the radio communication system, like a base station, or one or more network entities of a sensing system. In other words, the controller 326 allows for a communication with one or more entities of the system which provides the incident EM wave 312, for example, to receive the above mentioned control parameters/instructions which may be provided by a base station of the communication network so as to achieve a desired deflection of the incoming wave 312. For example, the RIS controller 326 may communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

The controller may identify itself as a further network entity of the communication network and may monitor respective paging occasions during which the controller 326 listens to a transmission of the wireless communication network on certain resources so as to determine whether some control information is included which is directed to the controller 326 including, for example, a command for selecting an operation mode, a certain control parameter or for activating/deactivating the RIS elements. When communicating with the entities of the communication network or the sensing network, the controller, for example, when being activated by a certain base station, may receive a configuration for the RIS.

The controller may send a report indicating, for example, a status or performance of the RIS or indicating information regarding the incident and/or outgoing EM waves 312, 318.

When not being used in the system, e.g., when being deactivated, upon receiving an activation or when being deployed or redeployed, the controller may identify or register the RIS towards the radio communication system or towards the sensing system so it may be used in the system.

For allowing a communication with the system providing the incident EM radiation 312, the controller 326 may communicate via a RIS communication device 328, like a transceiver, that is also part of the PV apparatus 300 and includes, for example, one or more antenna devices 330 integrated in the PV apparatus 300. For example, a part of a surface 304 of the body 302 may form an antenna 330 for transmitting/receiving signals provided by the communication system or sensing system.

In accordance with other embodiments, the apparatus 300 may include a PV controller, like a charge controller, or the apparatus 300 may be associated with an inverter having an inverter controller, and the RIS controller 326 may be part of the PV controller or may be part of the inverter controller. In accordance with yet other embodiments, the PV apparatus 300 may include a grid connection controller which is an entity controlling how much energy is taken from or fed into the grid. It may be located, e.g., in a home to manage the flow of energy under the constraint of battery status, solar production or demands in the house and/or the grid. For example, a microcontroller of the controller may implement control functionality both for the PV apparatus and for the RIS.

In accordance with further embodiments, the RIS controller 326 may communicate with one or further PV panels having the integrated RIS functionality in accordance with the embodiments described herein, or with one or more further RIS panels including only RIS elements, so as to coordinate among the apparatus 300 and the one or more further panels a desired RIS functionality for an incident EM wave 312. When coordinating or orchestrating the operation of the PV panel 300 together with one or more further PV panels with integrated RIS functionality and/or one or more further RIS panels, the controller may be referred to as providing edge intelligence for controlling, for example as a kind of master device, a plurality of other panels including RIS functionality which, in such a scenario, operate as a kind of slave device.

In accordance with further embodiments, the PV apparatus 300 may include an energy storage device 332, for example in the form of a battery, so as to store at least a part of the electrical energy obtained by converting the light incident on the surface 304. This energy may be used for operating the RIS, for example for operating the RIS controller 326 and/or the RIS communication device 328, as is schematically depicted by the dotted lines connecting the controller 326 and the radio device 328 with the battery 332. In accordance with other embodiments, the PV panel 300 may not include the battery 332, nevertheless, the controller 326 and the communication device 328 may be operated by electrical energy generated by converting the incident light 306 into electrical energy by the PV elements 308. In such embodiments a temporary storage device, like a capacitor, may be provided for buffering energy obtained by converting the light incident on the surface 304 for use by the RIS.

In accordance with further embodiments, the PV apparatus 300 is connectable to one or more other PV panels having an integrated RIS functionality or to one or more further RIS panels and may provide electrical energy generated by its PV elements 308 for use or storage by the other panels. Also, in case the amount of energy generated by the PV apparatus 300 is at or below a predefined threshold allowing for a reliable operation of the controller 326, the PV panel 300 may also receive additional energy from the other panels for operating the RIS.

In accordance with yet further embodiments, the PV apparatus 300 may include a global navigation satellite system, GNSS, positioning system 334, like GPS, BeiDou or GLONASS. By means of the positioning system 334, the PV panel 300 is aware of its location. In accordance with further embodiments, the PV panel 300 may use the RIS communication device 328 for a communication with one or more entities in the PV environment, for example with an operator of the PV apparatus, a grid to which the PV apparatus is connected or the manufacturer of the PV apparatus. For example, the PV apparatus may communicate the one or more of the following to the mentioned entities:
- a unique identification of the PV apparatus,
- an activation of the PV apparatus,
- a registration of the PV apparatus,
- a theft or misuse of the PV apparatus,
- a performance report of the PV apparatus,
- a signal for controlling the ganging or interconnecting with one or more further PV apparatus.

In accordance with embodiments, the RIS may act on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

For example, when considering a RIS element having a semi-transparent substrate and the transmission coefficient of which may be tuned, e.g. when employing RIS elements including LCD elements, part of the incident wave may be directed into the third direction, which represents a propagation direction of the transmitted, diffracted wave. For such a transmitted, diffracted wave, also the above described properties may be controlled by RIS controller using a control parameter and/or a control instruction.

In accordance with embodiments, the transmission, reflection and absorption properties of the RIS may be controlled using a control parameter and/or a control instruction.

In accordance with embodiments, the PV apparatus includes one or more energy harvesting elements in or at the surface. The energy harvesting element convert a radiation incident on the surface into electrical energy, e.g., for providing the electrical energy to the RIS for operating the RIS, e.g., for operating a RIS controller and/or a RIS communication device, or to other PV panels with RIS functionality. For example, the energy harvesting element may be the power source for operating the RIS during times when there is no or not sufficient energy generated by the PV elements, e.g., at night or when it is very cloudy during the day.

In accordance with embodiments, the PV apparatus further includes a radiation absorbing structure for converting an incident radiant energy into thermal energy or into electrical energy. The RIS may be controlled to act on the incident EM wave or EM beam such that cause a part of the incident EM wave or EM beam to be directed to the radiation absorbing structure. For example, the radiation absorbing structure may have body that absorbs radiation and heats up because the absorption converts the incident radiant energy into thermal energy.

### Second Aspect - RIS device with integrated power supply

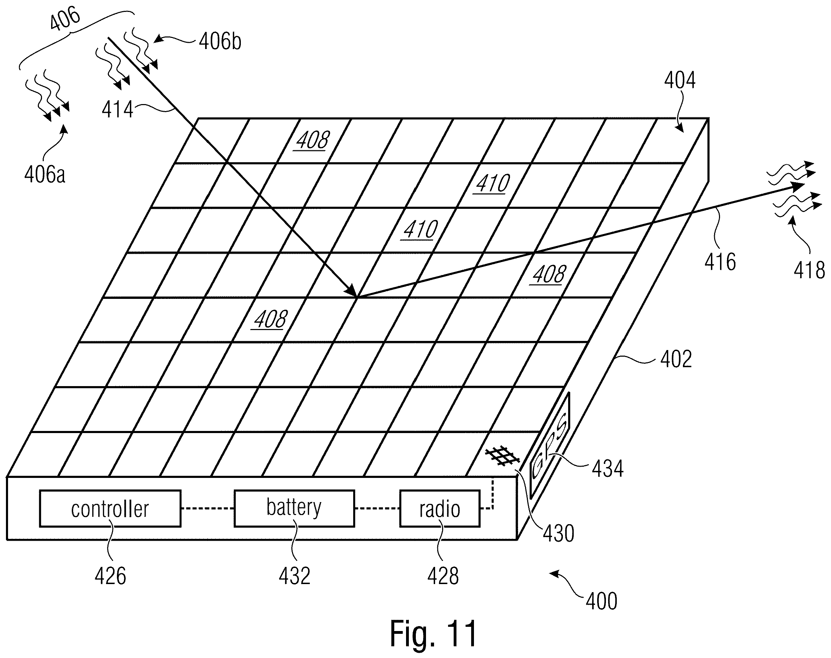

In accordance with embodiments of the second aspect of the present invention, a RIS apparatus or RIS device is provided that includes one or more elements for generating energy. Fig. 11 illustrates an embodiment of a RIS apparatus 400 including a body 402 having a surface 404 for receiving incident electromagnetic radiation 406. The RIS apparatus 400 includes in or at the surface 404 one or more reconfigurable intelligent surface, RIS, elements 408 receiving EM radiation 406 including a first part 406a and a second part 406b, referred to also as the incident EM wave 406b, to be reflected or redirected by the RIS from the incident direction or first direction 414 to at least one second direction 416 along which the redirected/reflected EM wave 418 propagates. The RIS apparatus 400 further includes in or at the surface 404 one or more second elements 410, also referred to as energy harvesting elements, to convert the first part 406a of the radiation 406 that is incident on the surface 404 of the body 402 into electrical energy that is used for operating the RIS, for example for operating a RIS controller 426 or a RIS communication device 428 which, in a similar way as described above with reference to Fig. 10, may include or may be connected to an antenna element 430 formed on a part of the surface 404 for a communication with one or more network entities of the system providing the incident EM wave 406b. In other words, the one or more RIS elements 408 and the one or more energy harvesting elements 410 are provided in or at the radiation receiving surface 404 of the RIS apparatus 400.

It is noted that Fig. 11 only indicates some RIS elements and energy harvesting elements, however, more or less RIS elements and energy harvesting elements may be provided, and the respective elements may be arranged in different kinds of patterns.

In accordance with embodiments, some or all of the RIS elements 408 provide a RIS for a certain incident EM wave so as to create, e.g., as described above with reference to Fig. 2, a deflected or reflected or diffused or transmitted or focused or diverged or collimated EM wave propagating along the second direction. The second direction may also be a direction extending through the RIS apparatus 400 so that in case the RIS apparatus 400 is formed at least in part from materials being transparent for the incident EM wave, the incident EM wave is transmitted, i.e., passes through RIS apparatus 400.

In accordance with embodiments, the number of energy harvesting elements may be selected such that an amount of energy obtained by converting the first part 406a of the incident EM radiation 406 into electrical energy is sufficient for operating the RIS apparatus 400, more specifically its active elements, like the RIS controller 426 and/or the RIS communication device 428.

In accordance with embodiments, the one or more energy harvesting elements may be of a first type that converts the first part 406a of the incident EM radiation 406 into electrical energy by the photovoltaic effect. In accordance with such embodiments, the first part 406a of the incident EM radiation 406 includes a part in the visible or invisible spectrum that may be converted by the photovoltaic effect. For example, the one or more energy harvesting elements 410 of the surface 404 may include one or more PV elements allowing for the conversion of the first part 406a of the incident EM radiation 406 into electrical energy by the PV effect.

In accordance with yet other embodiments, rather than providing in the energy harvesting elements capable of converting incoming radiation by the PV effect, the energy harvesting elements 410 may be of a second type that converts a radiation into electrical energy by electromagnetic induction. In accordance with such embodiments, the first part 406a of the incident EM radiation 406 that impinges on the surface 404 causes the generation of energy by electromagnetic induction.

In accordance with yet further embodiments, the RIS apparatus 400 is not limited to the use of energy harvesting elements of the same type, rather, the RIS type may include one or more energy harvesting elements of the first type and one or more energy harvesting elements of the second type.

The RIS controller 426 is provided to control the RIS or RIS elements so as to direct or reflect the second part 406b of the incident EM radiation 406 in the second direction 416. For example, the RIS controller 426, e.g., by means of a processor, may perform one or more of the following:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality

The RIS controller 426 may comprises a memory for holding the control parameter and/or the control instruction. In accordance with embodiments, the RIS controller 426 may be preconfigured with the control parameter and/or the control instruction. For example, the RIS controller may be preconfigured with the control parameter and/or the control instruction
- at a time of initial connection of the RIS apparatus 400 with a communication or sensing system making use of the RIS,
- at a time of provisioning the RIS apparatus 400 for operation with the communication or sensing system, e.g., by inserting a memory device or by activating an embedded memory device, or
- at a time of manufacturing the RIS apparatus 400, e.g., by storing the control parameter and/or the control instruction in the memory of the RIS controller 426.

In accordance with other embodiments, the RIS controller 426 may receive the control parameter and/or the control instruction from a remote unit, e.g., via a radio link from a network entity of a radio communication system or from a sensing system. Moreover, the RIS controller 426 may select e.g., responsive to a certain signaling from the network side, a certain set of control parameters for achieving a desired deflection or reflection of the second part 406b of the incident EM radiation 406.

The RIS controller 426 may configure the RIS elements 408 according to the one or more control parameters and/or the control instruction, so as to define one or more of the following properties of the EM wave or EM beam propagating along the second direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation, e.g., mixing products or frequency shifts.

The processor may communicate with one or more network entities of the radio communication system, like a base station, or one or more network entities of a sensing system. In other words, the controller 426 allows for a communication with one or more entities of the system which provides the second part 406b of the incident EM radiation 406, for example, to receive the above mentioned control parameters which may be provided by a base station of the communication network so as to achieve a desired deflection of the incoming EM wave 406a. For example, the RIS controller 426 may communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
an identification or registration of the RIS towards the radio communication system or towards the sensing system as a network entity.

The controller may identify itself as a further network entity of the communication network and may monitor respective paging occasions during which the controller 426 listens to a transmission of the wireless communication network on certain resources so as to determine whether some control information is included which is directed to the controller 426 including, for example, a command for selecting an operation mode, a certain control parameter or for activating/deactivating the RIS elements. When communicating with the entities of the communication network or the sensing network, the controller, for example, when being activated by a certain base station, may receive a configuration for the RIS.

The controller may send a report indicating, for example, a status or performance of the RIS or indicating information regarding the incident and/or outgoing EM waves 406a, 418.

When not being used in the system, e.g., when being deactivated, upon receiving an activation or when being deployed or redeployed, the controller may identify or register the RIS towards the radio communication system or towards the sensing system so it may be used in the system.

For allowing a communication with the system providing the incident EM wave 406a, the controller 426 may communicate via the RIS communication device 428, like a transceiver, that is also part of the RIS 400 and includes, for example, one or more antenna devices 430 integrated in the RIS or RIS apparatus 400. For example, a part of a surface 404 of the body 402 may form an antenna 430 for transmitting/receiving signals provided by the communication system or sensing system.

In accordance with other embodiments, the RIS apparatus 400 may include a charge controller for controlling the charging of a battery 432 of the RIS apparatus 400. For example, the charge controller may be part of the RIS controller 426. For example, a microcontroller of the controller may implement control functionality both for the RIs and the charge controller.

In accordance with further embodiments, the RIS controller 426 may communicate with one or further RISs having integrated energy harvesting functionality in accordance with the embodiments described herein, or with one or more further RIS panels including only RIS elements, so as to coordinate among the apparatus 400 and the one or more further panels a desired RIS functionality for the incident EM wave 406a. When coordinating or orchestrating the operation of the RIS panels, the controller may be referred to as providing edge intelligence for controlling, for example as a kind of master device, a plurality of other panels which, in such a scenario, operate as a kind of slave device.

In accordance with further embodiments, the RIS apparatus 400 may include an energy storage device 432, for example in the form of a battery, so as to store at least a part of the electrical energy obtained by the energy harvesting elements. This energy may be used for operating the RIS, for example for operating the RIS controller 426 and/or the RIS communication device 428, as is schematically depicted by the dotted lines connecting the RIS controller 426 and the RIS communication device 428 with the battery 332. In accordance with other embodiments, no battery may be provided, nevertheless, the controller 426 and the communication device 428 may be operated by electrical energy generated by the energy harvesting elements. In such embodiments a temporary storage device, like a capacitor, may be provided for buffering energy obtained by the energy harvesting elements.

In accordance with further embodiments, the RIS apparatus 400 is connectable to one or more other RIS channels having an integrated energy harvester or to one or more further RIS panels and may provide electrical energy generated by its energy harvesting elements 408 for use or storage by the other panels. Also, in case the amount of energy generated by the RIS apparatus 400 is at or below a predefined threshold allowing for a reliable operation of the controller 326, the PV panel 300 may also receive additional energy for operating the RIS from the other panels.

In accordance with yet further embodiments, the RIS apparatus 400 may include a global navigation satellite system, GNSS, positioning system 434, like GPS, BeiDou or GLONASS. By means of the positioning system 434, the RIS 400 is aware of its location. In accordance with further embodiments, the RIS 400 may use the RIS communication device 428 for a communication with one or more entities for signaling a theft or misuse of the apparatus 400.

In accordance with the embodiments as described thus far, the body 402 of the RIS apparatus 400 was comprised, at least, in part of a rigid structure, like a semiconductor substrate, in which the respective RIS elements and energy harvesting elements are formed. In accordance with other embodiments, the body 402 may be a multilayer structure including, for example, a circuit board to which respective RIS elements (see for example Fig. 3) as well as the additional energy harvesting elements are mounted in a certain pattern. However, the inventive approach in accordance with the second aspect is not limited to a rigid or non-flexible body 402, rather, in accordance with other embodiments, the body 402 of the RIS apparatus may be a flexible body, for example, it may be a film or a foil comprising both the RIS elements and the energy harvesting elements. For example, the body, at least in the part where no RIS elements and energy harvesting elements, are formed, may be transparent to light so that the flexible structure may be applied to or adhered to elements designed to pass light, such as windows, a building cladding, screens or divisors, in a way as also described above with reference to Fig. 9.

In accordance with embodiments the RIS apparatus 400 has a body 402 may including a single or multi-layered substrate, for example, a semiconductor substrate which, in turn, includes a plurality of semiconductor elements. The semiconductor elements include the RIS elements 408, like respective PIN diodes for switching on/off a reflecting element (see, e.g., reflecting element 232 in Fig. 3), and the energy harvesting elements 410.

In accordance with the embodiments described so far, it is assumed that the RIS apparatus 400 includes the RIS elements and the energy harvesting elements distributed on or at the surface 404 of the body 402 of the RIS apparatus in a certain pattern of RIS elements and energy harvesting elements. In other words, in the embodiments described so far, it was assumed that at or in the respective areas or sections of the surface either a RIS element or an energy harvesting element is provided. However, in accordance with other embodiments, the structure of the RIS apparatus may be such that it comprises in or at the surface 404 of body 402 respective elements, like semiconductor elements, that are configurable so as to either operate as RIS element or as energy harvesting element. For example, the apparatus body 402 may comprise a single or multi-layered substrate including, for example, a semiconductor substrate which includes a plurality of semiconductor elements that may be selectively configured to operate as a RIS element or as an energy harvesting element. For example, when making use of PIN diodes, such diodes may be configurable in such a way that when being turned off they operate as PIN photodiodes so that light incident on the surface 404 is converted into electrical energy in accordance with the photovoltaic effect, i.e., in such a case, the energy harvesting element is a PV element. When being turned on they may actuate a reflective element allowing reflection of the incident electromagnetic wave.

In accordance with further embodiments, some or all of the plurality of semiconductor elements may be selectively configured to operate as an element that neither harvests any electrical energy nor redirects or reflects the incident EM wave. Such an element may reflect the radiation 406 light and the EM wave like a mirror, or pass, like a window pane, the radiation light and the EM wave.

In accordance with yet further embodiments, some or all of the plurality of semiconductor elements may be selectively configured to operate as an element that combines energy harvesting and RIS functionality, e.g., as an element harvesting electrical energy as well as redirecting or reflecting the incident EM wave or EM beam.

In accordance with embodiments using configurable semiconductor elements, one or more of the mentioned semiconductor elements are configured as RIS elements, thereby defining the one or more RIS elements 408, and one or more of the semiconductor elements may be configured as energy harvesting element, thereby defining the one or more energy harvesting elements 310. In accordance with embodiments, a semiconductor element that is used as a PV element at one time may be configured into a RIS element for another time, as described in more detail above with reference to the first aspect of the present invention.

It is noted that, in accordance with embodiments, configuring the respective elements may also lead to situations in which all elements are RIS elements or in which all elements are energy harvesting elements.

In accordance with further embodiments, some or all of the plurality of semiconductor elements may be selectively configured to operate as a first specific element that neither harvests any electrical energy nor redirects or reflects the incident EM wave. Such an element may reflect the radiation like a mirror, or pass, like a window pane, the light and the EM wave.

In accordance with yet further embodiments, some or all of the plurality of semiconductor elements may be selectively configured to operate as a second specific element that combines RIS and energy harvesting functionality, e.g., as an element harvesting electrical energy and redirecting or reflecting the incident EM wave or EM beam.

When considering the above embodiments making use of configurable elements or non-configurable elements, for example, the PV apparatus 300 may include in total N semiconductor elements, with N being a positive integer greater than 1. Among these elements, there may be
- n1 semiconductor elements configured as PV element 308,
- n2 semiconductor elements configured as a RIS element 310,
- n3 semiconductor elements configured as a first specific element, and
- n4 semiconductor elements configured as a second specific element.

In accordance with embodiments, each of n1, n2, n3, n4 ≥ 0 and each of n1, n2, n3, n4 ≤ N. In other words, in accordance with embodiments,
- the number of PV elements in the PV apparatus may be from 0 to N,
- the number of RIS elements in the PV apparatus may be from 0 to N,
- the number of first specific elements in the PV apparatus may be from 0 to N,
- the number of second specific elements in the PV apparatus may be from 0 to N.

For example, in case of configurable elements n1, n2, n3, n4 and/or a pattern of respective PV elements, RIS elements, first specific elements and second specific elements may be set or determined responsive to an input from one or more of the following:
- a radio communication system or a sensing system using the EM wave or EM beam,
- a radio communication system or a sensing system different from the one using the EM wave or EM beam, e.g., a system experiencing interferences in view of the EM wave or EM beam.

In accordance with embodiments, the RIS element and the energy harvesting element are formed in a common layer of the semiconductor substrate, or the RIS element is formed in a first layer of the semiconductor substrate, and the energy harvesting element is formed in a second layer of the semiconductor substrate, with the first layer being closer to the surface 404 receiving the radiation 406 than the second layer, and transparent to the radiation 406, or with the second layer being closer to the surface 404 receiving the radiation 406, and transparent to the radiation 406.

In accordance with embodiments, the RIS may act on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

For example, when considering a RIS element having a semi-transparent substrate and the transmission coefficient of which may be tuned, e.g. when employing RIS elements including LCD elements, part of the incident wave may be directed into the third direction, which represents a propagation direction of the transmitted, diffracted wave. For such a transmitted, diffracted wave, also the above described properties may be controlled by RIS controller using a control parameter and/or a control instruction.

In accordance with embodiments, the transmission, reflection and absorption properties of the RIS may be controlled using a control parameter and/or a control instruction.

In accordance with embodiments, the PV apparatus further includes a radiation absorbing structure for converting an incident radiant energy into thermal energy or into electrical energy. The RIS may be controlled to act on the incident EM wave or EM beam such that cause a part of the incident EM wave or EM beam to be directed to the radiation absorbing structure. For example, the radiation absorbing structure may have body that absorbs radiation and heats up because the absorption converts the incident radiant energy into thermal energy.

### Third Aspect - System

Embodiments of a third aspect of the present invention provide a system of devices including RIS elements, for example one or more devices in accordance with the first aspect of the present invention and/or one or more devices in accordance with the second aspect of the present invention. Embodiment of the third aspect provide a system for a reflection or redirection of an electromagnetic, EM, wave, used by a radio communication system, like a 3GPP wireless communication network. In accordance with other embodiments, the communication system may be a different wireless communication network, like a WiFi system. In accordance with yet other embodiments, the system may also be a sensing system, like a radar system or a radio astronomy system.

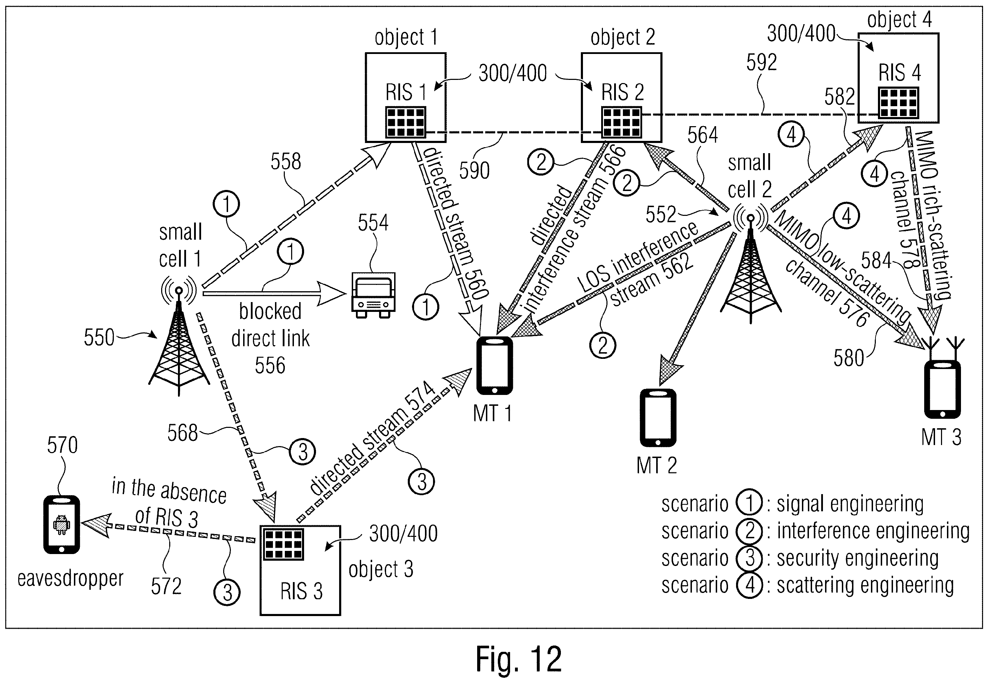

Fig. 12 illustrates a radio communication system in accordance with an embodiment of the third aspect of the present invention that includes the smart cells as illustrated by the smart cell base stations 550 and 552 providing the electromagnetic wave that is to be reflected or redirected by a plurality of RIS devices, RIS1 to RIS3. One, some or all of the RIS devices may be a PV panel 300 including integrated RIS functionality in accordance with the first aspect of the present invention, or may be a RIS device including energy harvesting elements in accordance with the second aspect of the present invention. As is further illustrated in Fig. 12, RIS elements RIS1, RIS2 and RIS4 may communicate with each other, as is indicated at 590 and 592, for example via the above described radio communication devices 328, 428 of the respective panels so that the functionality among the RIS elements may be configured, for example, under the control of a master RIS, like RIS2, while the other elements RIS1 and RIS4 are operated as slave elements. In accordance with other embodiments, in case energy is needed at one of the RIS devices, additional energy may be provided by the other RIS devices. Among the connected RIS devices RIS1, RIS2 and RIS4, only one may be connected to a base station or another network entity of the wireless communication system, like base station 552 for receiving information for configuring all of the connected RIS elements.

In the embodiment of Fig. 12, also a standalone device RIS3 is deployed, which may be a PV panel 300 having integrated RIS functionality or a RIS element 400 with an integrated harvesting device, and which is not connected to any other device but is controlled directly by one of the base stations 550 and 552.

The RIS devices RIS1 to RIS4, which are implemented by one or more of the inventive devices as described above with reference to the first and second aspects of the present invention, operate, for example, for implementing different scenarios ① to ④, like those described above with reference to Fig. 4. However, other than in Fig. 4, the system of Fig. 12 implements the advantages achieved in accordance with the first and second aspects of the present invention.

The signal engineering scenario ① may be implemented for allowing a communication between the small cell base station 550 and the user device MT1 also in situations in which a direct link is blocked. In the signal engineering scenario ① it is assumed that a direct path between the base station 550 and the user device MT1 is at least temporarily blocked, for example by a vehicle 554 passing by and blocking the direct link 556 between the small cell 550 and the user device MT1. In accordance with the signal engineering scenario ①, small cell base station 550 has knowledge about the position of the user device MT1 and about the positons of the respective inventive devices 300/400 in the system and it may direct a radio beam 558 towards object 1, more specifically towards the inventive device RIS1 which is configured, for example, by the base station 550 via a communication link, as described above with reference to Fig. 10 and Fig. 11, to direct the incident radio beam 558 towards the user device MT1 as is illustrated by the directed stream or reflected beam 560.

An interference engineering scenario ② may provide a direct link 562 between the small cell base station 552 and the user device MT2, and for interference engineering a line-of-sight, LoS, interference stream or beam 562 may be directed to the user device MT1 and a non-line-of-sight, NLoS, interference stream may be generated by directing a radio beam 564 from the small cell base station 552 to the inventive device RIS2 mounted on object 2 that is configured to reflect the incident beam 564 as the directed interference beam 566 directed from the inventive device RIS2 towards the user device MT1.

A security engineering scenario ③ may make use of an inventive device to avoid eavesdropping of a communication link. For example, a NLoS communication between the small cell base station 550 and the user device MT1 may cause a radio beam 568 to be directed towards object 3 and reflected by object 3 so that the scattered or reflected beam 572 propagates, in the absence of the inventive device RIS3, towards an eavesdropper 570. Providing the inventive device RIS3 at object 3 and controlling it to direct the beam 568 into a desired direction so as to achieve a desired directed beam 574 avoids security issues, like eavesdropping as described above, because beam 568 is directed, by means of the inventive device RIS3, into a desired direction towards user device MT1.

A scattering engineering scenario ④ may employ the inventive device. For example, small cell base station 552 may provide for a communication with the user device MT3 over a MIMO low-scattering channel 576 and over a MIMO rich-scattering channel 578. The low-scattering channel 576 is achieved directing a beam 580 directly from the base station 552 to the user device MT3, while the rich-scattering channel 578 is achieved by directing a beam 582 towards the inventive device RIS4 mounted on object 4 which causes redirecting the incident beam 582 into a reflected beam 584 directed to the user device MT3, thereby providing the rich-scattering channel 580.

### General

Embodiments of the present invention have been described in detail above, and the respective embodiments and aspects may be implemented individually or two or more of the embodiments or aspects may be implemented in combination.

In accordance with embodiments, the wireless communication system may include a terrestrial network, or a non-terrestrial network, or networks or segments of networks using as a receiver an airborne vehicle or a space-borne vehicle, or a combination thereof.

In accordance with embodiments of the present invention, a user device comprises one or more of the following: a power-limited UE, or a hand-held UE, like a UE used by a pedestrian, and referred to as a Vulnerable Road User, VRU, or a Pedestrian UE, P-UE, or an on-body or hand-held UE used by public safety personnel and first responders, and referred to as Public safety UE, PS-UE, or an IoT UE, e.g., a sensor, an actuator or a UE provided in a campus network to carry out repetitive tasks and requiring input from a gateway node at periodic intervals, a mobile terminal, or a stationary terminal, or a cellular loT-UE, or a vehicular UE, or a vehicular group leader (GL) UE, or a sidelink relay, or an loT or narrowband loT, NB-loT, device, or wearable device, like a smartwatch, or a fitness tracker, or smart glasses, or a ground based vehicle, or an aerial vehicle, or a drone, or a moving base station, or road side unit (RSU), or a building, or any other item or device provided with network connectivity enabling the item/device to communicate using the wireless communication network, e.g., a sensor or actuator, or any other item or device provided with network connectivity enabling the item/device to communicate using a sidelink the wireless communication network, e.g., a sensor or actuator, or any sidelink capable network entity.

In accordance with embodiments of the present invention, a network entity comprises one or more of the following: a macro cell base station, or a small cell base station, or a central unit of a base station, an integrated access and backhaul, IAB, node, or a distributed unit of a base station, or a road side unit (RSU), or a remote radio head, or an AMF, or an MME, or an SMF, or a core network entity, or mobile edge computing (MEC) entity, or a network slice as in the NR or 5G core context, or any transmission/reception point, TRP, enabling an item or a device to communicate using the wireless communication network, the item or device being provided with network connectivity to communicate using the wireless communication network.

In the following, additional embodiments and aspects of the invention will be described which can be used individually or in combination with any of the features and functionalities and details described herein.

According to a first aspect, a photovoltaic, PV, apparatus for the conversion of light into electrical energy comprises: a surface to receive incident light, one or more PV elements in or at the surface, the PV element to convert light incident on the surface into electrical energy by the photovoltaic effect, and one or more reconfigurable intelligent surface, RIS, elements in or at the surface, the RIS element operating as reconfigurable intelligent surface, RIS, to direct or reflect one or more incident electromagnetic, EM, waves or one or more incident EM beams incident on the surface from an incident first direction into one or more outgoing EM waves or one or more outgoing EM beams propagating along at least one second direction.

According to a second aspect when referring back to the first aspect, the RIS acts on the incident EM wave or EM beam so as to create a deflected or reflected or diffused or transmitted or focused or diverged or collimated EM wave or EM beam propagating along the second direction.

According to a third aspect when referring back to the first aspect, the RIS acts on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

According to a fourth aspect when referring back to any one of the first to third aspects, the RIS element comprises one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

According to a fifth aspect when referring back to any one of the first to fourth aspects, the apparatus comprises one or more solar panels, and each of the solar panels comprises an array of PV elements, like solar cells or solar modules, and one or more RIS elements located in a space between the PV elements.

According to a sixth aspect when referring back to any one of the first to fourth aspects, the apparatus comprises one or more solar panels, and each of the solar panels comprises an array of elements, the elements comprising one or more PV elements, like a solar cell or a solar module, and one or more RIS elements.

According to a seventh aspect when referring back to the first to fourth aspects, the apparatus comprises one or more solar panels, and each of the solar panels comprises a plurality of PV elements, like solar cells or solar modules, arranged in a first layer of a body of the PV apparatus, and a plurality of RIS elements arranged in a second layer of the body, and the first layer is closer to the surface receiving the incident light than the second layer, and is transparent to the EM wave or EM beam, or the second layer is closer to the surface receiving the incident light than the first layer, and is transparent to light.

According to an eighth aspect when referring back to any one of the first to fourth aspects, the apparatus is a solar cell, and the apparatus comprises a semiconductor substrate, wherein a PV element, like a photodiode, is formed in a first area of the semiconductor substrate, and a RIS element is formed in a second area of the semiconductor substrate.

According to a ninth aspect when referring back to any one of the first to fourth aspects, the apparatus comprises a plurality of semiconductor elements, the semiconductor elements are selectively configurable to operate as
- a PV element, or
- a RIS element, or
- a first element neither converting any incident light into electrical energy by the photovoltaic effect nor redirecting or reflecting the incident EM wave or EM beam, e.g., as an element that reflects, like a mirror, or passes, like a window pane, the light and the EM wave or EM beam, or
- a second element converting any incident light into electrical energy by the photovoltaic effect and redirecting or reflecting the incident EM wave or EM beam.

According to a tenth aspect when referring back to the ninth aspect, the apparatus comprises
- N semiconductor elements, N being a positive integer greater than 1,
- n1 semiconductor elements configured as PV element,
- n2 semiconductor elements configured as a RIS element,
- n3 semiconductor elements configured as a first element, and
- n4 semiconductor elements configured as a second element,
with each of n1, n2, n3, n4 ≥ 0, and each of n1, n2, n3, n4 ≤ N.

According to an eleventh aspect when referring back to the tenth aspect, each of n1, n2, n3, n4 and/or a pattern of respective PV elements, RIS elements, first elements and second elements is determined responsive to an input from one or more of the following:
- a radio communication system or a sensing system using the EM wave or EM beam,
- a radio communication system or a sensing system different from the one using the EM wave or EM beam, e.g., a system experiencing interferences in view of the EM wave or EM beam,
- an operator of the PV apparatus,
- a grid to which the PV apparatus is connected,
- a manufacturer of the PV apparatus.

According to a twelfth aspect when referring back to any one of the ninth to eleventh aspects, a PV element is reconfigured as a RIS element in one or more of the following situations:
- if an amount of light convertible into electrical energy is at or below a predefined threshold, e.g., during night time or in case of a shading of the PV element from the light,
- if an amount of light convertible into electrical energy is at or above a predefined threshold, e.g., during excessively bright periods of time, like an incident solar energy level at or above a threshold, or in case of a saturation of an energy storage device, like a battery, connected to the PV apparatus, or in case a network or grid to which the PV apparatus is connected does not accept any electrical energy,
- if a radio communication system or a sensing system using the EM wave or EM beam requests an increase of an amount of RIS provided for the EM wave or EM beam, e.g., in case a coverage need and/or a capacity need in a radio communication system increases beyond a predefined threshold.

According to a thirteenth aspect when referring back to any one of the eighth to twelfth aspects, the PV element and the RIS element are formed in a common layer of the semiconductor substrate, or the PV element is formed in a first layer of the semiconductor substrate, and the RIS element is formed in a second layer of the semiconductor substrate, with the first layer being closer to a surface receiving the incident light than the second layer, and transparent to the EM wave or EM beam, or with the second layer being closer to the surface receiving the incident light than the first layer, and transparent to light.

According to a fourteenth aspect when referring back to any one of the first to thirteenth aspects, the PV apparatus comprises a single layer or multilayer rigid structure including the PV elements and the RIS elements, like a semiconductor substrate or a support plate, or a single layer or multilayer flexible structure including the PV elements and the RIS elements, like a foil or a film.

According to a fifteenth aspect when referring back to any one of the first to fourteenth aspects, the light to be converted into electrical energy by the PV effect comprises light in the visible or invisible part of the electromagnetic spectrum, e.g., visible light in the wavelengths from 380 nm to 700 nm or ultraviolet radiation or infrared radiation, and the EM wave or EM beam to be directed or reflected from the incident first direction to the second/third direction comprises an EM wave or EM beam in the electromagnetic spectrum used by a radio communication system, like a 3GPP wireless communication network or a WiFi system, or by a sensing system, like radar and or radio astronomy.

According to a sixteenth aspect when referring back to any one of the first to fifteenth aspects, the PV apparatus comprises a RIS controller, the RIS controller to configure the RIS to direct or reflect the incident EM wave or EM beam in the second/third direction.

According to a seventh aspect when referring back to the sixteenth aspect, the RIS controller comprises a processor configured to perform one or more of the following operations:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

According to an eighteenth aspect when referring back to the seventeenth aspect, the RIS controller comprises a memory holding the control parameter and/or the control instruction, the RIS controller being preconfigured with the control parameter and/or the control instruction or receiving the control parameter and/or the control instruction from a remote unit, e.g., via a radio link from a network entity of a radio communication system or from a sensing system, and the control parameter and/or the control instruction defines one or more of the following properties of the EM wave or EM beam propagating along the second/third direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation, e.g., mixing products or frequency shifts.

According to a nineteenth aspect when referring back to any one of the sixteenth to eighteenth aspects, the RIS controller is to communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

According to a twentieth aspect when referring back to any one of the sixteenth to nineteenth aspects, the PV apparatus comprises a PV controller, like a charge controller, and/or an inverter and/or a grid connection controller, wherein the PV controller or an inverter controller or the grid connection controller further comprises the RIS controller.

According to a twenty-first aspect when referring back to any one of the first to twentieth aspects, the PV apparatus comprises a RIS communication device for a communication with one or more entities, like a base station or a user device, of a radio communication system or a sensing system using the EM wave or EM beam to operate.

According to a twenty-second aspect when referring back to the twenty-first aspect, the RIS communication device further allows for a communication with one or more entities of the PV environment, like an operator of the PV apparatus, the grid to which the PV apparatus is connected or the manufacturer of the PV apparatus, and wherein the PV apparatus may communicate one or more of the following:
- a unique identification of the PV apparatus,
- an activation of the PV apparatus,
- a registration of the PV apparatus,
- a theft or misuse of the PV apparatus,
- a performance report of the PV apparatus,
- a signal for controlling the ganging or interconnecting with one or more further PV apparatus.

According to a twenty-third aspect when referring back to any one of the first to twenty-second aspects, the PV apparatus comprises a Global Navigation Satellite System, GNSS, positioning system, like GPS, BeiDou, or GLONASS.

According to a twenty-fourth aspect when referring back to any one of the first to twenty-third aspects, the RIS is operated using at least a part of the electrical energy obtained by converting the light incident on the surface.

According to a twenty-fifth aspect when referring back to any one of the first to twenty-fourth aspects, the PV apparatus comprises one or more energy harvesting elements in or at the surface, the energy harvesting element to convert a radiation incident on the surface into electrical energy, and to provide the electrical energy to the RIS for operating the RIS, e.g., for operating a RIS controller and/or a RIS communication device.

According to a twenty-sixth aspect when referring back to any one of the first to twenty-fifth aspects, the PV apparatus comprises an energy storage for storing electrical energy, e.g., energy obtained by converting the light incident on the surface or energy obtained by the energy harvesting element, the energy storage coupled to the RIS for providing electrical energy for operating the RIS, e.g., for operating a RIS controller and/or a RIS communication device.

According to a twenty-seventh aspect when referring back to any one of the first to twenty-sixth aspects, the PV apparatus is connectable to one or more PV panels with integrated RIS functionality and/or one or more further RIS panels, and the PV apparatus is to provide the electrical energy generated by the PV elements or by the energy harvesting elements for use or storage to the one or more PV panels with integrated RIS functionality and/or to the one or more further RIS panels, and/or the PV apparatus is to receive additional electrical energy for operating the RIS, e.g., for operating the RIS controller and/or the RIS communication device, from the one or more PV panels with integrated RIS functionality and/or from the one or more further RIS panels, e.g., if an amount of energy generated by the PV apparatus is at or below a predefined threshold.

According to a twenty-eighth aspect when referring back to any one of the first to twenty-seventh aspects, the PV apparatus comprises a radiation absorbing structure for converting an incident radiant energy into thermal energy or into electrical energy, wherein the RIS acts on the incident EM wave or EM beam so as to cause a part of the incident EM wave or EM beam to be directed to the radiation absorbing structure.

According to a twenty-ninth aspect, an apparatus for the reflection or redirection of one or more incident electromagnetic, EM, waves or one or more incident EM beams used by a radio communication system, like a 3GPP wireless communication network or a WiFi system, or by a sensing system, like radar and or radio astronomy, from an incident first direction into one or more outgoing EM waves or one or more outgoing EM beams propagating along at least one second direction, comprises: a surface to receive the incident EM wave or EM beam, one or more reconfigurable intelligent surface, RIS, elements in or at the surface, the RIS element operating as reconfigurable intelligent surface, RIS, to reflect or redirect the incident EM wave or EM beam from the incident first direction to the second direction, and one or more energy harvesting elements in or at the surface, the energy harvesting element to convert a radiation incident on the surface into electrical energy, and to provide the electrical energy to the RIS for operating the RIS, e.g., for operating a RIS controller and/or a RIS communication device.

According to a thirtieth aspect when referring back to the twenty-nineth aspect, the RIS acts on the incident EM wave or EM beam so as to create a deflected or reflected or diffused or transmitted or focused or diverged or collimated EM wave or EM beam propagating in the second direction.

According to a thirty-first aspect when referring back to the twenty-nineth aspect, the RIS acts on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

According to a thirty-second aspect when referring back to any one of the twenty-nineth to thirty-first aspects, the RIS element comprises one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

According to a thirty-third aspect when referring back to any one of the twenty-nineth to thirty-second aspects, the radiation incident on the surface comprises a radiation in the visible or invisible part of the electromagnetic spectrum, e.g., visible light in the wavelengths from 380 nm to 700 nm or ultraviolet radiation or infrared radiation, and the one or more energy harvesting elements are configured to convert the radiation into electrical energy by the photovoltaic effect.

According to a thirty-fourth aspect when referring back to any one of the twenty-nineth to thirty-third aspects, the radiation incident on the surface comprises the radiation of the EM wave or EM beam to be directed or reflected to the second/third direction, and the one or more energy harvesting elements are configured to convert the radiation into electrical energy by electromagnetic induction.

According to a thirty-fifth aspect when referring back to any one of the twenty-nineth to thirty-fourth aspects, the apparatus comprises a single layer or multilayer rigid structure including the RIS elements and the energy harvesting elements, like a semiconductor substrate or a support plate, or a single layer or multilayer flexible structure including the RIS elements and the energy harvesting elements, like a foil or a film.

According to a thirty-sixth aspect when referring back to any one of the twenty-nineth to thirty-fifth aspects, the apparatus comprises a RIS controller, the RIS controller to configure the RIS to direct or reflect the incident EM wave or EM beam in the second/third direction.

According to a thirty-seventh aspect when referring back to the thirty-sixth aspect, the RIS controller comprises a processor configured to perform one or more of the following operations:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

According to a thirty-eighth aspect when referring back to the thirty-seventh aspect, the RIS controller comprises a memory holding the control parameter and/or the control instruction, the RIS controller being preconfigured with the control parameter and/or the control instruction or receiving the control parameter and/or the control instruction from a remote unit, e.g., via a radio link from a network entity of a radio communication system or from a sensing system, and the control parameter and/or the control instruction defines one or more of the following properties of the EM wave or EM beam propagating in the second/third direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation, e.g., mixing products or frequency shifts.

According to a thirty-nineth aspect when referring back to any one of the thirty-sixth to thirty-eighth aspects, the RIS controller is to communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

According to a fortieth aspect when referring back to any one of the twenty-nineth to thirty-nineth aspects, the apparatus comprises a RIS communication device for a communication with one or more entities, like a base station or a user equipment device, of a radio communication or of a sensing system using the EM wave or EM beam.

According to a forty-first aspect when referring back to any one of the twenty-nineth to fortieth aspects, the apparatus comprises a Global Navigation Satellite System, GNSS, positioning system, like GPS, BeiDou, or GLONASS.

According to a forty-second aspect when referring back to any one of the twenty-nineth to forty-first aspects, the apparatus comprises a plurality of semiconductor elements, the semiconductor elements are selectively configurable to operate as
- a RIS element, or
- an energy harvesting element, or
- a first element neither converting an incident radiation into electrical energy nor redirecting or reflecting the incident EM wave or EM beam, e.g., as an element that reflects, like a mirror, or passes, like a window pane, the radiation and the EM wave or EM beam, or
- a second element converting an incident radiation into electrical energy and redirecting or reflecting the incident EM wave or EM beam.

According to a forty-third aspect when referring back to the forty-second aspect, the apparatus comprises
- N semiconductor elements, N being a positive integer greater than 1,
- n1 semiconductor elements configured as RIS element,
- n2 semiconductor elements configured as an energy harvesting element,
- n3 semiconductor elements configured as a first element, and
- n4 semiconductor elements configured as a second element,
with each of n1, n2, n3, n4 ≥ 0, and each of n1, n2, n3, n4 ≤ N.

According to a forty-fourth aspect when referring back to the forty-third aspect, each of n1, n2, n3, n4 and/or a pattern of respective RIS elements, energy harvesting elements, first elements and second elements is determined responsive to an input from one or more of:
- a radio communication system or a sensing system using the EM wave or EM beam,
- a radio communication system or a sensing system different from the one using the EM wave or EM beam, e.g., a system experiencing interferences in view of the EM wave or EM beam.

According to a forty-fifth aspect when referring back to any one of the forty-second to forty-fourth aspects, an energy harvesting element is reconfigured as a RIS element in one or more of the following situations:
- if an amount of radiation convertible into electrical energy is at or below a predefined threshold, e.g., during night time or in case of a shading of the PV element from the light,
- if an amount of radiation convertible into electrical energy is at or above a predefined threshold, e.g., during excessively bright periods of time, like an incident solar energy level at or above a threshold, or in case of a saturation of an energy storage device, like a battery, connected to the PV apparatus, or in case a network or grid to which the PV apparatus is connected does not accept any electrical energy,
- if a radio communication system or a sensing system using the EM wave or EM beam requests an increase of an amount of RIS provided for the EM wave or EM beam, e.g., in case a coverage need and/or a capacity need in a radio communication system increases beyond a predefined threshold.

According to forty-sixth aspect when referring back to any one of the twenty-nineth to forty-fifth aspects, the apparatus comprises an energy storage for storing the electrical energy obtained by converting the radiation incident on the surface.

According to a forty-seventh aspect when referring back to any one of the twenty-nineth to forty-sixth aspects, the apparatus is connectable to one or more PV panels with integrated RIS functionality and/or one or more further RIS panels, and the apparatus is to provide the electrical energy generated by the one or more energy harvesting elements for use or storage to the one or more PV panels with integrated RIS functionality and/or to the one or more further RIS panels, and/or the apparatus is to receive additional electrical energy for operating the RIS, e.g., for operating the RIS controller and/or the RIS communication device, from the one or more PV panels with integrated RIS functionality and/or from the one or more further RIS panels, e.g., if an amount of energy generated by the apparatus is at or below a predefined threshold.

According to a forty-eighth aspect when referring back to of any one of the twenty-nineth to forty-seventh aspects, the apparatus comprises radiation absorbing structure for converting an incident radiant energy into thermal energy or into electrical energy, wherein the RIS acts on the incident EM wave or EM beam so as to cause a part of the incident EM wave or EM beam to be directed to the radiation absorbing structure.

According to a forty-nineth aspect, a system for a reflection or redirection of an electromagnetic, EM, wave used by a radio communication system, like a 3GPP wireless communication network or a WiFi system, or by a sensing system, like radar and or radio astronomy, from an incident first direction to a second direction, comprises: plurality of apparatuses which are communicatively linked, wherein the plurality of apparatuses comprising one or more PV apparatuses according to any one of the first to twenty-eighth aspects and/or one or more apparatuses according to any one of the twenty-nineth to forty-eighth aspects, and wherein at least one of the apparatuses is to control the RIS functionality provided by the plurality of apparatuses.

Although some aspects of the described concept have been described in the context of an apparatus, it is clear that these aspects also represent a description of the corresponding method, where a block or a device corresponds to a method step or a feature of a method step. Analogously, aspects described in the context of a method step also represent a description of a corresponding block or item or feature of a corresponding apparatus.

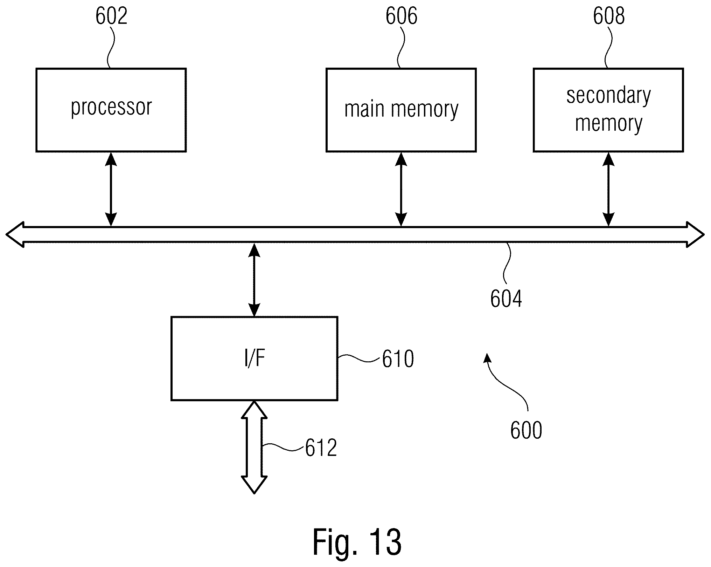

Various elements and features of the present invention may be implemented in hardware using analog and/or digital circuits, in software, through the execution of instructions by one or more general purpose or special-purpose processors, or as a combination of hardware and software. For example, embodiments of the present invention may be implemented in the environment of a computer system or another processing system. Fig. 13 illustrates an example of a computer system 600. The units or modules as well as the steps of the methods performed by these units may execute on one or more computer systems 600. The computer system 600 includes one or more processors 602, like a special purpose or a general-purpose digital signal processor. The processor 602 is connected to a communication infrastructure 604, like a bus or a network. The computer system 600 includes a main memory 606, e.g., a random-access memory, RAM, and a secondary memory 608, e.g., a hard disk drive and/or a removable storage drive. The secondary memory 608 may allow computer programs or other instructions to be loaded into the computer system 600. The computer system 600 may further include a communications interface 610 to allow software and data to be transferred between computer system 600 and external devices. The communication may be in the from electronic, electromagnetic, optical, or other signals capable of being handled by a communications interface. The communication may use a wire or a cable, fiber optics, a phone line, a cellular phone link, an RF link and other communications channels 612.

The terms "computer program medium" and "computer readable medium" are used to generally refer to tangible storage media such as removable storage units or a hard disk installed in a hard disk drive. These computer program products are means for providing software to the computer system 600. The computer programs, also referred to as computer control logic, are stored in main memory 606 and/or secondary memory 608. Computer programs may also be received via the communications interface 610. The computer program, when executed, enables the computer system 600 to implement the present invention. In particular, the computer program, when executed, enables processor 602 to implement the processes of the present invention, such as any of the methods described herein. Accordingly, such a computer program may represent a controller of the computer system 600. Where the disclosure is implemented using software, the software may be stored in a computer program product and loaded into computer system 600 using a removable storage drive, an interface, like communications interface 610.

The implementation in hardware or in software may be performed using a digital storage medium, for example cloud storage, a floppy disk, a DVD, a Blue-Ray, a CD, a ROM, a PROM, an EPROM, an EEPROM or a FLASH memory, having electronically readable control signals stored thereon, which cooperate or are capable of cooperating with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention may be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier. In other words, an embodiment of the inventive method is, therefore, a computer program having a program code for performing one of the methods described herein, when the computer program runs on a computer.

A further embodiment of the inventive methods is, therefore, a data carrier or a digital storage medium, or a computer-readable medium comprising, recorded thereon, the computer program for performing one of the methods described herein. A further embodiment of the inventive method is, therefore, a data stream or a sequence of signals representing the computer program for performing one of the methods described herein. The data stream or the sequence of signals may for example be configured to be transferred via a data communication connection, for example via the Internet. A further embodiment comprises a processing means, for example a computer, or a programmable logic device, configured to or adapted to perform one of the methods described herein. A further embodiment comprises a computer having installed thereon the computer program for performing one of the methods described herein.

In some embodiments, a programmable logic device, for example a field programmable gate array, may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein are apparent to others skilled in the art. It is the intent, therefore, to be limited only by the scope of the impending patent claims and not by the specific details presented by way of description and explanation of the embodiments herein.

## Claims

1. An apparatus for the reflection or redirection of one or more incident electromagnetic, EM, waves or one or more incident EM beams used by a radio communication system, like a 3GPP wireless communication network or a WiFi system, or by a sensing system, like radar and or radio astronomy, from an incident first direction into one or more outgoing EM waves or one or more outgoing EM beams propagating along at least one second direction, the apparatus comprising:
a surface to receive the incident EM wave or EM beam,
one or more reconfigurable intelligent surface, RIS, elements in or at the surface, the RIS element operating as reconfigurable intelligent surface, RIS, to reflect or redirect the incident EM wave or EM beam from the incident first direction to the second direction, and
one or more energy harvesting elements in or at the surface, the energy harvesting element to convert a radiation incident on the surface into electrical energy, and to provide the electrical energy to the RIS for operating the RIS, e.g., for operating a RIS controller and/or a RIS communication device.

2. The apparatus of claim 1, wherein the RIS acts on the incident EM wave or EM beam so as to create a deflected or reflected or diffused or transmitted or focused or diverged or collimated EM wave or EM beam propagating in the second direction.

3. The apparatus of claim 1, wherein the RIS acts on the incident EM wave or EM beam so as to cause
- a reflection of a first part of the incident EM wave or EM beam propagating along the second direction, e.g., away from a surface of the RIS, and
- a transmission of a second part of the incident EM wave or EM beam propagating along a third direction, e.g., through the surface of the RIS.

4. The apparatus of any one of claims 1 to 3, wherein the RIS element comprises one or more of the following:
- an antenna-array-based structure, e.g., a structure having reflect-arrays with tunable, e.g., varactor-tuned, resonators, a structure of Micro-Electro-Mechanical-Systems, MEMS, elements, or a structure of Liquid Cristal Display, LCD, elements, or
- a meta-surface-based structure, e.g., a frequency selective active base structure utilizing PIN diodes, a structure having tunable meta-surfaces with binary phase state capabilities, a structure of binary elements based meta-surfaces, or a structure of PIN diode-equipped cells based meta-surfaces.

5. The apparatus of any one of claims 1 to 4, wherein the radiation incident on the surface comprises a radiation in the visible or invisible part of the electromagnetic spectrum, e.g., visible light in the wavelengths from 380 nm to 700 nm or ultraviolet radiation or infrared radiation, and the one or more energy harvesting elements are configured to convert the radiation into electrical energy by the photovoltaic effect.

6. The apparatus of any one of claims 1 to 5, wherein the radiation incident on the surface comprises the radiation of the EM wave or EM beam to be directed or reflected to the second/third direction, and the one or more energy harvesting elements are configured to convert the radiation into electrical energy by electromagnetic induction.

7. The apparatus of any one of claims 1 to 6, comprising a single layer or multilayer rigid structure including the RIS elements and the energy harvesting elements, like a semiconductor substrate or a support plate, or a single layer or multilayer flexible structure including the RIS elements and the energy harvesting elements, like a foil or a film.

8. The apparatus of any one of claims 1 to 7, comprising
a RIS controller, the RIS controller to configure the RIS to direct or reflect the incident EM wave or EM beam in the second/third direction, and/or
a RIS communication device for a communication with one or more entities, like a base station or a user equipment device, of a radio communication or of a sensing system using the EM wave or EM beam.

9. The apparatus of claim 8, wherein the RIS controller comprises a processor configured to perform one or more of the following operations:
- configure the RIS according to one or more predefined or stored control parameters and/or control instructions,
- communicate with one or more network entities, like a base station, of the radio communication system or of the sensing system using the EM wave or EM beam,
- communicate with one or more further PV panels with integrated RIS functionality and/or one or more further RIS panels for coordinating RIS functionality,
- communicate with respective RIS controllers of one or more further PV panels with integrated RIS functionality and/or of one or more further RIS panels for coordinating RIS functionality.

10. The apparatus of claim 9, wherein
the RIS controller comprises a memory holding the control parameter and/or the control instruction, the RIS controller being preconfigured with the control parameter and/or the control instruction or receiving the control parameter and/or the control instruction from a remote unit, e.g., via a radio link from a network entity of a radio communication system or from a sensing system, and
the control parameter and/or the control instruction defines one or more of the following properties of the EM wave or EM beam propagating in the second/third direction:
- a desired phase shift,
- a desired signal-to-noise ratio, SNR,
- a desired signal-to-noise-and-interference ratio, SINR,
- a desired beamwidth,
- a desired direction,
- a desired polarization,
- a desired cross-polar discrimination, XPD,
- a desired orbital angular momentum, OAM,
- a desired amplification or attenuation,
- a desired channel rank,
- a desired beam sweep,
- a desired functionality of the RIS deployment,
- a desired functionality of the sensing elements,
- a desired functionality of the transmitting elements,
- a desired frequency translation ,e.g., mixing products or frequency shifts.

11. The apparatus of any one of claims 8 to 10, wherein the RIS controller is to communicate with a network entity of the radio communication system or of the sensing system so as to receive and/or transmit one or more of the following:
- one or more operation commands, e.g., for turning on/off the RIS or for selecting an operation mode of the RIS, like an uplink, UL, mode or a downlink, DL, mode,
- a configuration of the RIS,
- a report, e.g., a report indicating a status or performance of the RIS or indicating information regarding the incident and/or outgoing EM wave or EM beam by measuring and reporting channel states,
- an identification or registration of the RIS towards the radio communication system or towards the sensing system as a network entity.

12. The apparatus of any one of claims 1 to 11, wherein
the apparatus comprises a plurality of semiconductor elements,
the semiconductor elements are selectively configurable to operate as
- a RIS element, or
- an energy harvesting element, or
- a first element neither converting an incident radiation into electrical energy nor redirecting or reflecting the incident EM wave or EM beam, e.g., as an element that reflects, like a mirror, or passes, like a window pane, the radiation and the EM wave or EM beam, or
- a second element converting an incident radiation into electrical energy and redirecting or reflecting the incident EM wave or EM beam.

13. The apparatus of any one claims 1 to 12, comprising an energy storage for storing the electrical energy obtained by converting the radiation incident on the surface.

14. The apparatus of any one of claims 1 to 13, comprising
radiation absorbing structure for converting an incident radiant energy into thermal energy or into electrical energy,
wherein the RIS acts on the incident EM wave or EM beam so as to cause a part of the incident EM wave or EM beam to be directed to the radiation absorbing structure.

15. A system for a reflection or redirection of an electromagnetic, EM, wave used by a radio communication system, like a 3GPP wireless communication network or a WiFi system, or by a sensing system, like radar and or radio astronomy, from an incident first direction to a second direction, the system comprising:
a plurality of apparatuses which are communicatively linked,
wherein the plurality of apparatuses comprising one or more apparatuses according to any one of claims 1 to 14, and
wherein at least one of the apparatuses is to control the RIS functionality provided by the plurality of apparatuses.
